(19) Europäisches Patentamt / European Patent Office / Office européen des brevets

(11) **EP 2 433 311 B1**

(12) **EUROPEAN PATENT SPECIFICATION**

(45) Date of publication and mention
of the grant of the patent:
**23.12.2015 Bulletin 2015/52**

(21) Application number: **10777278.2**

(22) Date of filing: **21.05.2010**

(51) Int Cl.:
**H01L 31/18** (2006.01)    **G07C 3/14** (2006.01)

(86) International application number:
**PCT/CA2010/000772**

(87) International publication number:
**WO 2010/132998 (25.11.2010 Gazette 2010/47)**

(54) **PROCESS FOR IMPROVING THE PRODUCTION OF PHOTOVOLTAIC PRODUCTS**

VERFAHREN ZUR VERBESSERTEN HERSTELLUNG VON PHOTOVOLTAIKPRODUKTEN

PROCESSUS PERMETTANT D'AMÉLIORER LA PRODUCTION DE PRODUITS PHOTOVOLTAÏQUES

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **22.05.2009 US 180744 P**
**22.09.2009 US 272407 P**

(43) Date of publication of application:
**28.03.2012 Bulletin 2012/13**

(73) Proprietor: **Aurora Solar Technologies (Canada) Inc.**
**North Vancouver BC V7P 3N4 (CA)**

(72) Inventors:
• **DEANS, Gordon**
**West Vancouver, British Columbia V7W 3Bl (CA)**
• **HEAVEN , E . Michael**
**North Vancouver, British Columbia V7G 2E7 (CA)**

(74) Representative: **Harrison, Robert John**
**24IP Law Group**
**Sonnenberg Fortmann**
**Patent- und Rechtsanwälte**
**Herzogspitalstraße 10a**
**80331 München (DE)**

(56) References cited:
**US-A1- 2004 203 321     US-A1- 2005 066 241**
**US-A1- 2008 306 621     US-B1- 6 415 191**
**US-B1- 6 675 058        US-B1- 7 257 459**

• **INTERNATIONAL LABOUR ORGANIZATION: 'In-line inspection; Good Practice Guide; Factory Improvement programme', [Online] 12 March 2008, XP008148080 Retrieved from the Internet: <URL:www.ilofip.org/GPGs/In-line%20Inspection.pdf> [retrieved on 2010-07-29]**

## Description

## FIELD OF THE INVENTION

The present invention relates to the field of Photovoltaic ("PV") products and their manufacture and, in particular, to means of increasing efficiencies in such manufacture.

## BACKGROUND OF THE INVENTION

Photovoltaic ("PV") products and devices directly convert absorbed illumination to electrical energy with the advantage of being non-polluting and silent in operation. They are readily adapted to either a centralized or distributed power generating system and as such, are an attractive alternative to fossil fuels and nuclear power sources. The relatively high cost of PV power has been a historical limitation upon its use; however, high volume processes for the preparation of crystalline silicon (c-Si) and thin film PV devices have now decreased the cost of PV materials. In spite of this, cost of manufacture remains an on-going concern.

The most imperative overall need in the PV industry is to reduce the cost of manufactured PV products sufficiently to achieve grid parity. For wafer, cell and module manufacturers, this drive for cost reduction has three aspects: improved product technology, providing higher power output for a given market price; reduced per-unit cost of materials and capital equipment through economies of scale; and improved manufacturing efficiency and yield. The present Invention relates to improving efficiency and yield in the manufacture of PV products. To date, these have not been adequately addressed.

PV wafers, cells and modules are generally inspected manually or by single-point devices at varying intervals in the production process - mostly at the end of the production line. This means that while defects may be caught, accept/reject decisions can only be made on the limited data available at the point of inspection. Additionally, prior to the present inventions and except for the raw material acceptance stage (at the beginning of the line) and the final inspection and grading (at the end of the line), in-line unit-by-unit inspection of products during production is generally rudimentary or non-existent.

Further, wafer, cell and module production facilities frequently operate on a FIFO (First In, First Out) basis only. This means that the products are graded and sorted only at the end of the production line, with varying degrees of inspection at other points in production.

Additionally, most facilities currently monitor their production by measuring the operating parameters of each tool (such as gas flow, power consumption, temperature), not the actual production results by directly inspecting the products themselves at each stage of the process (except for occasional off-line sampling). See for example the disclosure in Patent Cooperation Treaty application published under number WO2009/026661.

This produces several deficiencies. First, it gives the facility operator only one option if a process tool begins to operate outside of acceptable parameters ("operational drift"), or generates an error - adjust or fix the tool, which may involve a shutdown. Manual adjustments or outright shutdowns are costly, and it may be that an isolated operational drift can be tolerated, if inspection of the products themselves demonstrates that enough products are remaining in acceptable grades, or if appropriate downstream adjustments may be made to resolve or mitigate identified potential problems with the products so that sufficient final products are of an acceptable grade or grades.

Conversely, a series of shifts in operating parameters that fall below unacceptable thresholds, but occur over a number of tools, can lead to a quality problem that is unobserved until final inspection and grading - and therefore very hard to isolate since no single tool is at fault. Also, defects may be introduced that have nothing to do with the operating parameters of the tools (such as handling-induced marking or airborne contamination at tool ingress or egress). Monitoring of tool parameters alone will not find the source of these problems and consequently cannot lead to a resolution of the problems.

As the industry grows, solutions to the above needs, and as provided within the scope of this invention, can have significant financial impact. For example, if a 50 MW cell production line generates approximately $100M to $125M of finished goods value per annum, a yield improvement of only 2 percent would provide an additional $2M to $3.5M of margin per year.

Accordingly there is an unmet need for a method and system to more efficiently control the throughput of photovoltaic cells in a cell manufacturing production line.

## SUMMARY OF THE INVENTION

Unless the context indicates otherwise the term "production step or steps" means a particular step or steps of the manufacture of PV products which produce measurable differences in the product. And an "intermediate production step or steps" means a production step or steps after the first production step in the production line and before the final step in the production line.

The present invention provides a production line method and system for PV device fabrication which is highly efficient, both in terms of required labour, time and the economical use of PV raw material and production material at each stage of the production process. These and other advantages of the present invention will be readily apparent from the drawings, discussion and description which follow.

The process of the present invention improves PV manufacturing efficiencies in the following ways:

    1) Reduction or elimination of excessive production cost and waste due to poor or late detection, separation for remedial processing, or removal for recycling, of defective unfinished PV wafers, cells or modules (sometimes referred to herein as "Work in Progress" or "WIP" units) from the production line. One mode of achieving this within the scope of the invention: Provide for grading, separation or rejection, and (optionally) substitution of individual wafers, cells or modules much earlier in the process in an efficient manner so as not to unduly disrupt the production line. This can be achieved through a combination of end-to-end WIP unit tracking, coordinated in-line inspection, predictive WIP unit grading, distributed WIP unit buffering and closed-loop facility-wide inter-tool material handling. The predictive WIP unit grading and closed loop handling also allows the manufacturer to dynamically adjust grading and rejection thresholds based on end-to-end cost optimization calculated in real time.

2) Improvement of production line yield.
One mode of achieving this within the scope of the invention: Through the use of the same technologies as above, plus WIP unit re-sequencing, WIP units that have flaws that are amenable to improvement via particular changes to equipment operational parameters in downstream process tools, are grouped together. The invention provides real-time feed-forward information to the process tools in question that specifies the operational changes to the tools in order to implement downstream solutions to bring the defective group to a acceptable grade by the time the processing of the WIP unit group is completed in the production line. The result is mitigation of the flaws by compensating physical, chemical or electrical characteristics in order to resolve or mitigate in the finished products, problems detected earlier in the manufacturing process. In addition the invention provides real-time feedback for "run-to-run" adaptation in process tool operating parameters to reduce re-occurrence of flaws as much as is possible.

3) Mitigation of throughput bottlenecks, caused by a lack of tools and/or inefficiencies that precludes controlling the order that certain grades of WIP units flow through and exit the production line(s). This can be broken down into two desired outcomes:

a) Higher throughput of a desired grade of WIP units in a facility; and
b) Rapid recognition and isolation of production issues, to more readily take corrective action to maximize quality or optimize the production line.

One mode of achieving this within the scope of the invention: Through the use of the same technologies as above, the inventions solve part (a) of this need by providing for prioritization of individual WIP units, based on their (predicted) grade as they move through the production process. This will give the manufacturer a faster or more predictable unit-per-hour production rate for a desired grade of WIP units (order-based production), resulting in higher profitability from the production line investment Part (b) is solved by providing the means to monitor and assess production results directly on the WIP units - both end-to-end and tool-by-tool - in real time, and to centrally consolidate these measurements to pinpoint issues among and between individual tools. This is accomplished using one or more of: (i) coordinated in-line inspection, (ii) end-to-end WIP unit tracking and (iii) a production performance database built and maintained by the system that can be used to monitor, analyze and report on performance (sometimes referred to herein as "True Production Measurement").

In an embodiment of the invention a method of manufacturing photovoltaic products in a manufacturing production line of a series of production steps is provided where the following steps are undertaken at each of a predetermined plurality of intermediate production steps of the production line:

(a) assessing each photovoltaic product for suitability based on predetermined criteria for a preferred product, to obtain real time assessment results for the product at each production step;

(b) storing the assessment results for that product by production step, in a memory;

(c) assigning a grade to each photovoltaic product, based on either:

(i) the assessment results for that product at that step;

(ii) a comparison of the assessment results for that product at that step to statistical analysis of assessment results of previously processed photovoltaic products at that step; or

(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;

(d) storing the grade for that product at such production step, in a memory; and

(e) using the grade to determine when and how the product is processed through downstream production steps.

Alternatively the method can include associating all of the products in the production line at a particular step, having the same stored grade, together in a group for further processing as a group.

As another alternative, the method can include: for groups having grades indicative of products outside of the predetermined tolerances, adjusting the downstream production equipment of the production line to process each such group of products with the same grade so as to bring the group within the predetermined tolerances; and then processing the group together using the downstream production equipment as so adjusted, to bring the products of the group within the predetermined tolerances.

In a further alternative the grade assignable to a product at a production step is associated with information for adjusting the downstream production equipment so as to bring the group associated with the grade within the predetermined tolerances and wherein the downstream production equipment is adjusted accordingly for processing of that group.

In a further alternative, if groups at a step are identified as outside of the predetermined tolerances, process changes are made upstream of the step to production equipment to bring future products produced within the predetermined tolerances.

In a further alternative groups identified as outside of the predetermined tolerances at a step are prioritised for further processing after groups at that step which are within the predetermined tolerances.

In a further alternative groups at a step are prioritised for further processing based on the grade of the group, with groups of grades having more significant deviations from the predetermined tolerances positioned for processing behind groups with grades representing lesser deviations from the predetermined tolerances.

In a further alternative a method of manufacturing photovoltaic products in a manufacturing production line of a series of production steps is provided which includes at step (e) above the steps of:

(a) comparing, by a processor, said grade to a plurality of grades of other previously processed photovoltaic products in a knowledge base stored in a memory, to identify a similar grade, the similar grade being a grade associated with previous products having similar grading information, wherein said knowledge base further comprises information as to the outcome of the grade at further process steps in the line and wherein said knowledge base further comprises production line adjustment information which bring the similar grade products to an acceptable tolerance;

(b) based on the outcome information of the similar grade, determining a predicted outcome of the photovoltaic product at one or more further processing steps in the production line; and

(c) if the predicted outcome is outside of the predetermined tolerance at a further processing step, providing the production line adjustment information for that further processing step to adjust the production line to process the product.

In a further alternative, at step (c) immediately above:

(a) if the predicted outcome is outside of the predetermined tolerance at a further processing step, storing the product in a product group of products with the same or similar grades until a predetermined number of products are stored;

(b) providing the production line adjustment information for that step to adjust the production line prior to processing the products as a group; and

(c) inserting the product group after the adjustments are made and processing them as a group to achieve the desired performance tolerances.

In a further alternative, the grading information is based on either:

(a) the assessment results for that product at that step;

(b) statistical analysis of assessment results of previously processed photovoltaic products at that step; or

(c) a comparison of cumulative historical assessment results for the product throughout its past production steps in comparison to a statistical analysis of historical cumulative assessment results of previously processed photovoltaic products over the same production steps.

In a further alternative a method of manufacturing photovoltaic products in a manufacturing production line of a series of production steps is provided, includes at step (e) above the steps of:

(a) logging past assessments of a plurality of photovoltaic products at predetermined production steps in a knowledge base stored in a memory, each assessment determined by past processing of photovoltaic products;

(b) logging past courses of action taken at the production steps in response to said past assessments, and associated outcomes, in said knowledge base;

(c) characterizing at least one of said associated outcomes as a positive outcome;

(d) comparing, by a processor, the grade of the photovoltaic product at a production step to said past assessments to determine a predicted assessment for said product; and

(e) providing one of said courses of action associated with said positive outcome as the course of action to take in further processing of the product.

In a further alternative a computer program is adapted to perform the method of claim 1. In a further alternative an apparatus adapted to manufacture photovoltaic products includes:

(a) circuitry adapted to assess each photovoltaic product for suitability based on predetermined criteria for a preferred product, to obtain assessment results for the product at each production step;
(b) circuitry adapted to store the assessment results for that product by production step, in a memory;
(c) circuitry adapted to assign a grade to each photovoltaic product, based on either:

(i) the assessment results for that product at that step;
(ii) a comparison of the assessment results for that product at that step to statistical analysis of assessment results of previously processed photovoltaic products at that step; or
(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;
(d) circuitry adapted to store the grade for that product at such production step, in a memory; and
(e) circuitry adapted to use the grade to determine when and how the product is processed through downstream production steps.

In another embodiment a data processing apparatus comprises means for carrying out the method of claim 1.
In a further alternative the said data processing apparatus further comprises means for carrying out a method comprising:

(f) associating all of the products in the production line at a particular step, having the same stored grade, together in a group for further processing as a group.

## DESCRIPTION OF THE DRAWINGS

Figure 1 is a diagram of the system architecture of the present invention, showing both the Production, Measurement and Control System (the PMC System) and the Measurement and Handling Units (MS Units)

Figure 2 is a schematic illustration of a manufacturing production line comprising a series of production steps of a typical c-Si cell manufacturing facility utilizing the PMC System and a series of MS Units of the present invention;

Figure 3 is a flowchart diagram of the PMC System operational flow;

Figure 4 is a diagram of the relationship between the PMC System, MS Units and other production tools on one hand and the enterprise resource planning and manufacturing execution system on the other hand, of a manufacturing facility;

Figure 5 is a diagram of the functional architecture of the PMC System and a MS Unit;

Figure 6 is a diagram of linear and matrix layouts or architectures of a manufacturing facility employing the PMC System and MS Units of this invention;

Figure 7 is a flowchart of higher level operational flow of a PMC System;

Figure 8 is a diagram of hardware architecture of an MS Unit 14 having handling and measurement functionality;

Figure 9 is a diagram of hardware architecture of an MS Unit 14 having only measurement functionality; and

Figure 10 is a flowchart of higher level operational flow of an MS Unit having handling and measurement functionality.

## DETAILED DESCRIPTION

### 1. Product Line Overview

In a preferred embodiment the present invention provides a Production Enhancing System ("PES System") that optimizes the output of a PV factory by continuously evaluating the quality of WIP units through the manufacturing process and managing WIP unit mix and flow to generate improvements to economic value of the finished product relative to the cost of raw materials.

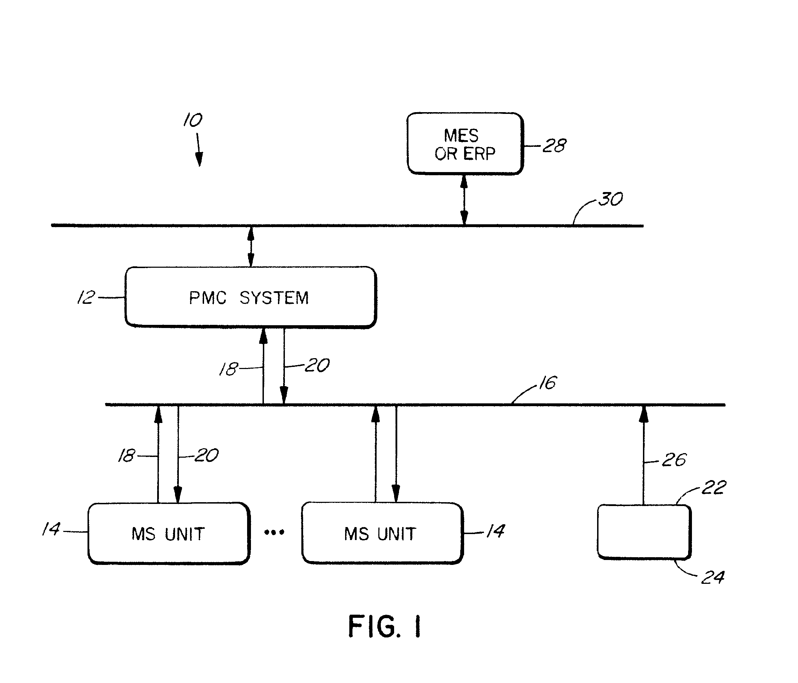

The PES System consists of two inter-linked products: a process measurement and control system ("PMC System"), and a set of inter-tool measurement and sorting units ("MS Units"). The MS Unit has two variants - a measurement-only version (the "Measurement MS Unit"), and a combined measurement and handling version (the "Measurement/Handling MS Unit"). The MS Unit of the preferred embodiment is designed for use in c-Si PV wafer or cell factories as an example. The PES System is shown generally in Figure 1.

The PES System 10 comprises a PMC System 12 connected through a ProfiNET/Ethernet IP/EtherCAT 16 to one or more inter-tool measurement and sorting units, the MS Units 14.

The PMC System 12 generally consist of a computer server comprising system software for operating a manufacturing production line for manufacturing photovoltaic products, including receiving measurement data 18 from the MS Units 14 and providing queuing and transfer instructions 20 to the MS Units 14. Each MS Unit 14 provides measurement data 18 through the ProfiNET/Ethernet IP/EtherCAT 16 to the PMC System 12 for the particular production stage or step of the production line with which the MS Unit is configured to operate. Similarly, each MS Unit 14 receives queuing and transfer instructions 20, as appropriate for each particular MS Unit 14 from the PMC System 12. Instructions 20 being appropriate for the particular MS Unit's operations in respect of the production step or steps for which it has been configured and in association with which it operates.

It should also be noted that other tools or instruments 22 and 24 may be connected to ProfiNET/Ethernet IP/EtherCAT 16 to provide appropriate tool or instrument measurement data 26 to PMC System 12.

As well, PMC System 12 can be configured to operate in association with manufacturing enterprise systems 28 of the operator of the manufacturing production line through Ethernet 30 to send and receive data, instructions and other information between system 28 and PMC System 12 in order to ensure that the manufacturing production line operates within the parameters of that operator's entire system.

The Measurement MS Unit inspects and grades each WIP unit according to programmable criteria, and passes this information to its controlling PMC System. The Measurement/Handling MS Unit also unloads WIP units from a process tool, and sorts, buffers or rejects each WIP unit according to instructions from the PMC System received after the Measurement/Handling MS Unit has passed the WIP unit grading information to the PMC System. In this case, the output of each MS Unit (as input to the next production stage) is then an optimally ordered "lot" (for batch processes) or "flow" (for continuous processes) of WIP units.

The PMC System consolidates measurement results from any number of MS Units and other sources (such as WIP unit flow rates and status measurements from PVD devices, laser isolation systems, etc.). The PMC System uses this information to direct each of the Handling/Measurement MS Units installed in a given facility to buffer or sequence individual WIP units for advancement to their respective next stage of production. The goal is to exploit variations in WIP unit quality - continuously and in-line with the end-to-end production process - to maximize the aggregate economic value of finished goods in the facility.

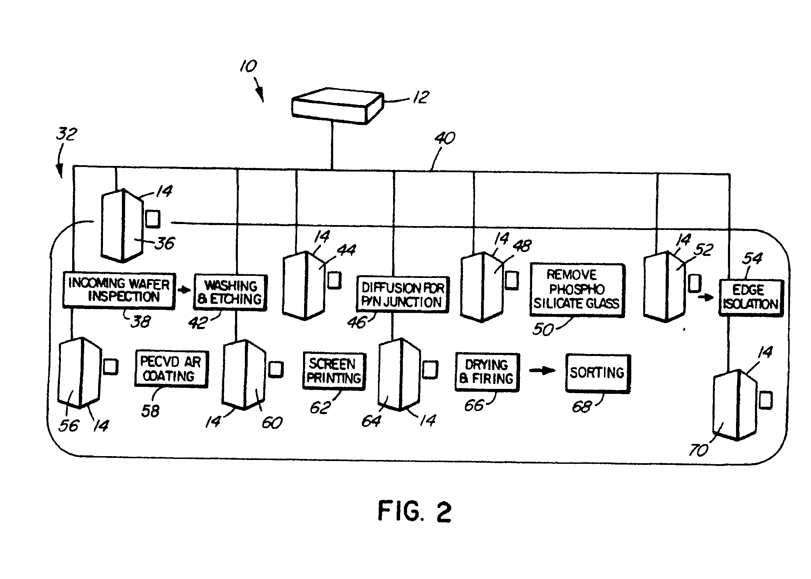

Figure 2 is an example of a PMC System and Measurement/Handling MS Units in the context of a c-Si cell manufacturing line is shown above. The MS Units are placed at the beginning and end of the line (incoming wafer inspection and sorting, respectively), and are also placed between the process tools in the line (which is simplified for the purposes of this illustration).

PMC System 12 of PES System 10 is shown connected to several MS Units 14 shown in a manufacturing production line 32.

An initial MS Unit 36 is associated at the beginning of the c-Si cell manufacturing process shown in Figure 2 to inspect the incoming wafer at incoming wafer production step 38. MS Unit 36 inspects the incoming wafer for physical defects such as edge chips and cracks and sends information to PMC System 12 by means of communication bus 40 PMC System 12 analyzes and interprets the data received from MS Unit 36 in order to grade the wafer by one or more of the methods below and provides MS Unit 36 with instructions to either discard (or recycle), buffer (that is placed in a specific group for processing as a group) or advance individual wafers so inspected by MS Unit 36 to the next production step in production line 32.

The next step in production line 32 is the washing and etching step 42 where the wafer from production step 38 is washed and etched by wet processing tools that remove saw marks, remove edge irregularities and create a surface texture to enhance photon capture. A second MS Unit 44 inspects the wafer exiting washing and etching step 42 for physical characteristics related to satisfactory removal of the saw marks and edge irregularities as well as creation of surface texturing and sends that information to PMC System 12 through communication bus 40. PMC System 12 then analyzes that data in order to grade the wafer by one or more of the methods below and sends instructions to second MS Unit 44 to either discard (or recycle), buffer or advance the wafer so inspected to the next step.

The next step in production line 32 is the diffusion for P/N junction step 46 where the wafer is doped to create the emitter. This may be implemented in two ways. In the first way, it may be implemented whereby the wafer has a wet film of dopant applied to its top surface, the film is dried, and then the dopant is diffused into the wafer in a furnace. In the second way, it may be implemented whereby the wafer is inserted into a furnace and the dopant is simultaneously introduced in a gaseous form during diffusion. After treatment at step 46 the wafer is examined by MS Unit 48 which inspects the wafer for the dopant concentration in the emitter and sends that information through communication bus 42 PMC System 12. If the first way is used, the wet film depth and distribution on the wafer may also be examined prior to the wafer entering the furnace. PMC System 12 then analyzes that data in order to grade the wafer by one or more of the methods below and provides instructions to MS Unit 48 to either discard (or recycle), buffer or advance the wafer so inspected to the next step in production line 32.

The next step in production line 32 is the removal of phospho-silicate glass and etching of the top and bottom surfaces of the wafer step 50 where the wafer is again processed through a series of wet etching tools. A further MS Unit 52 inspects the wafer leaving the removed phospho-silicate glass step 50 to determine the adherence of these etching steps to the desired specification, and sends that information to PMC System 12 which analyzes the data in order to grade the wafer by one or more of the methods below and returns instructions to MS Unit 52 to either discard (or recycle), buffer or advance the wafer to the next step of the manufacturing production line 32.

In this example at this step, after removal of phospho-silicate glass and top and bottom etching, the wafer is checked by MS Unit 52 to determine the sheet resistance or dopant concentration at particular locations and depths within the wafer. If these values are above or below a predetermined range of values as defined by the operator of the PES System 10, this measurement may be used at this production step for classifying or grading the wafer at a particular predetermined class or grade for sheet resistance or dopant content and distribution. This classification/grade is combined with other classification/grades on other criteria that were determined for that wafer in previous steps (such as the RMS texture peak-to-valley distance after isotropic texturing) to determine an aggregate grade for the wafer, to be compared by PMC System 12 to its database (or knowledge base) of aggregate grades at that production step (that is phospho-silicate glass step 50).

The next step in the production line 32 is edge isolation step 54 where the wafer is etched around its perimeter to remove any short circuits between the emitter and base and inspected by MS Unit 56 for the continuity and depth of such etching. That information is sent to PMC System 12 by bus 40 where the information is used to create an aggregate grade for step 54. At this time, the aggregate grade may be used to make the decision as to whether the wafer will be discarded (or recycled), buffered (that is placed in a specific group for processing as a group) or advanced to the next step. Alternatively, or additionally, the information may be used by PMC System 12 to establish a grade specific to step 54 (that is not on an aggregate basis with previous steps) to compare with a database/knowledgebase of grades specific to that step. As a further alternative, or further In addition, the information from MS Unit 56 can be used to determine a grade, *per se*, without comparing the information to a database/knowledgebase of prior WIP units. The grade information of each, or any one or more, of these alternative methods of grading is then used to assess the wafer to determine whether either discard (or recycle), buffer (with other like wafers) or advance the wafer so inspected to the next step in production line 32. PMC System 12 sends instructions to MS Unit 56 to either discard (or recycle), buffer (with other like wafers) or advance the wafer so inspected to the next step in production line 32.

This process of grading the wafer (or any other WIP unit) can be applied at any selected process step described above or as follows, of production line 32. That is grading by one or more of:

> 1) An analysis of the information from MS Unit 14, *per se*;
> 2) A comparison of the information from MS Unit 14 to a database/knowledge base of information about previously processed comparable WIP Units at that step; and/or
> 3) A comparison of the information from MS Unit 14 at that step and selected previous process steps to a database/knowledge base of information about previously processed comparable WIP Units at that step and the selected previous steps.

The next step in the production line 32 is the application of the anti-reflective coating (ARC) step 58 where the wafer is coated with a silicon nitride or equivalent chemical. MS Unit 60 inspects the wafer leaving ARC step 58 for the color, depth and uniformity of the coating. That information is sent through communication bus 40 to PMC System 12 where it is graded by one or more of the grading methods above. PMC System 12 then provides instructions to MS Unit 60 to either discard, buffer or advance the wafer to the next step in the production line 32.

The next step in the production line 32 is the printing step 62 where the wafer has the back electrical contacts, the back aluminum surface and the front electrical fingers and busbars applied. MS Unit 64 then inspects the wafer exiting screen printing step 62 for the physical quality of these printings and sends that information through communication bus 40 to PMC System 12. PMC System 12 then analyzes that information in order to grade the wafer by one or more of the methods above and provides instructions to MS Unit 64 to either discard, buffer or advance the wafer to the next step in the production line 32. Optionally, there could be a separate inspection after application of each of the back contact, back aluminum and front contacts.

The next step in the production line 32 is the annealing of the printed metal features applied in step 62 at step 66 where the wafer is passed through an annealing furnace. The wafer is then automatically advanced to the next step, the sorting step 68 can be seen here that not every step in the manufacturing production line 32 may necessarily include an MS Unit appropriately configured for that step. A wafer may proceed automatically from one step to another without the intervening measurement by any MS Unit 14 or any control from PMC System 12 at that step. Much will depend on the needs of a particular operator of the manufacturing production line 32. Inspection can also occur after the annealing furnace. That inspection would be to determine that the metal features had penetrated into the wafer correctly and maintained a correct physical orientation on the front and back surfaces of the wafer.

After sorting steps 68 the wafer is subjected to an inspection by MS Unit 70 which inspects for any final criteria as may be determined by the manufacturer, such as bar codes or visible defects introduced during sorting as the final inspection step in the manufacturing production line 32. MS Unit 70 then provides that information to PMC System 12 through communication bus 40. PMC System 12 then analyzes that information in order to grade the wafer by one or more of the methods above and provides instructions to MS Unit 70 to either discard or advance the wafer to a storage area or packaging area for shipment.

The MS Units provides a complementary function to the process tools by linking them together to achieve a continuous production flow - whether in a single production line or across multiple lines within a large facility.

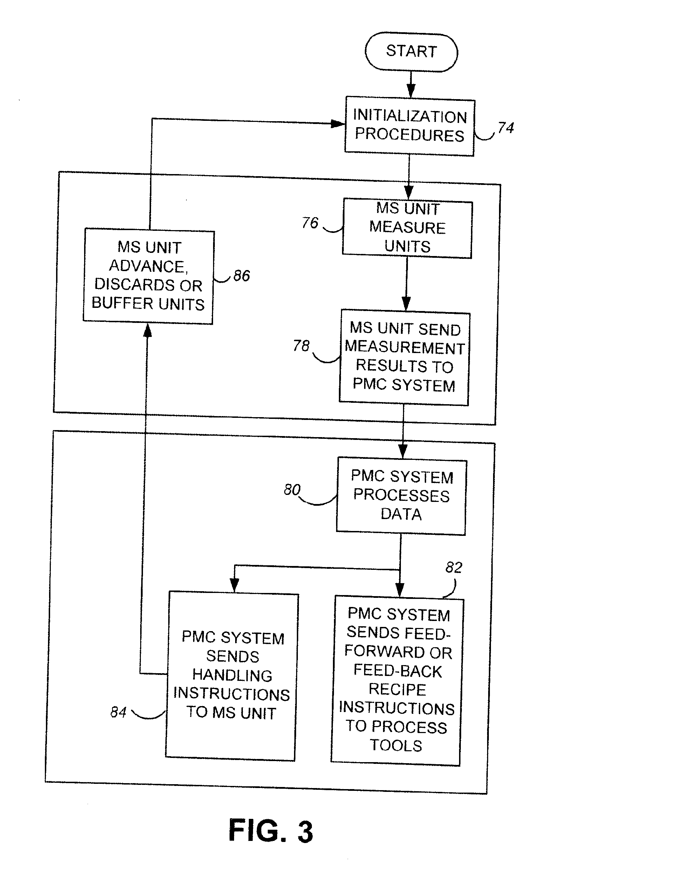

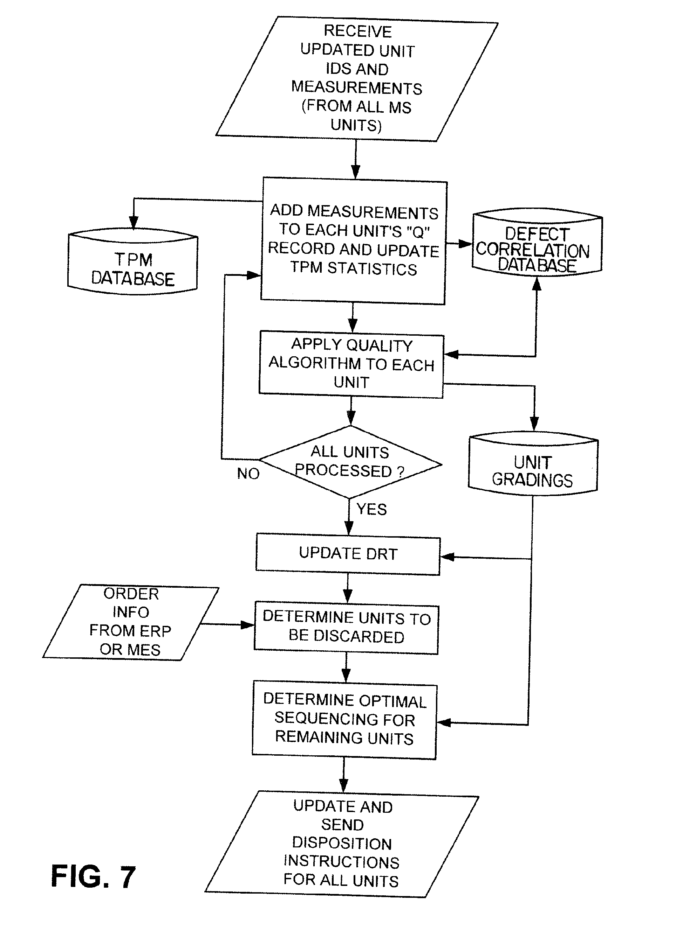

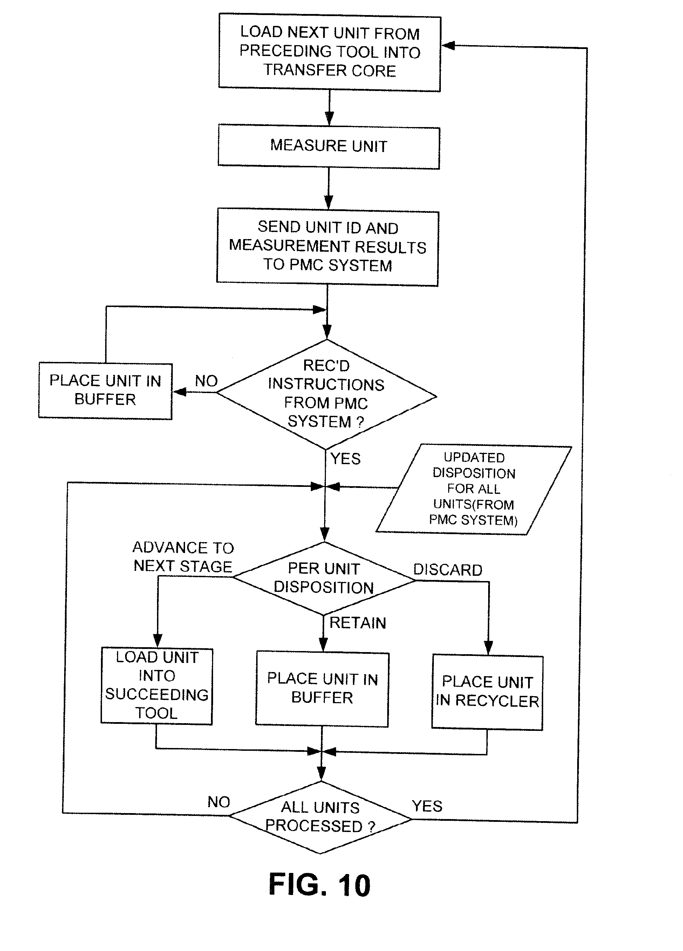

The general mainline operational flow of the PES System is shown in the flowchart of Figure 3. Note that this flowchart does not include system maintenance, administration, and provisioning operations. More detailed operational flows for each of the PMC System and MS Unit are shown in Figures 7 and 10, as discussed below.

In general, the MS Units 14 function as the measurement and first level control computers. MS Units 14 talk to the PMC System 12 across the network, sharing measurement and control data so that the PMC system 12 can make decisions on the overall process. For example, there may be 5-10 MS Units 14 measuring and controlling each step (or selected steps) of the process. A set of algorithms in the PMC System 12 solve the optimization of the flow of wafers (or other WIP units) through production line 32 - deciding which wafers are grouped together (based on their individual allocated grades), how they are processed downstream, and other types of processing decisions, which are passed on to the MS Units 14 for controlling the operations at particular process steps. Together, these make a PES System 10.

Referring to Figure 3, the PES System operational flow is shown by means of a flowchart. The PES System goes through an initialization procedure at 74. Then at each production step of the manufacturing production line 32 (Figure 2) the MS Unit conducts appropriate measurements of the workpiece, which can be a photovoltaic cell, wafer, or module (sometimes called a WIP unit) at 76. MS Unit then sends measurement results to the PMC System at 78. The PMC System receives and processes the data at 80. Based on that information, the PMC System can either or both send feed forward or feedback recipe instructions to process tools at 82 and/or send handling instructions to the relevant MS Unit at 84. The appropriate MS Unit then either advances, discards or buffers the workpiece at 86.

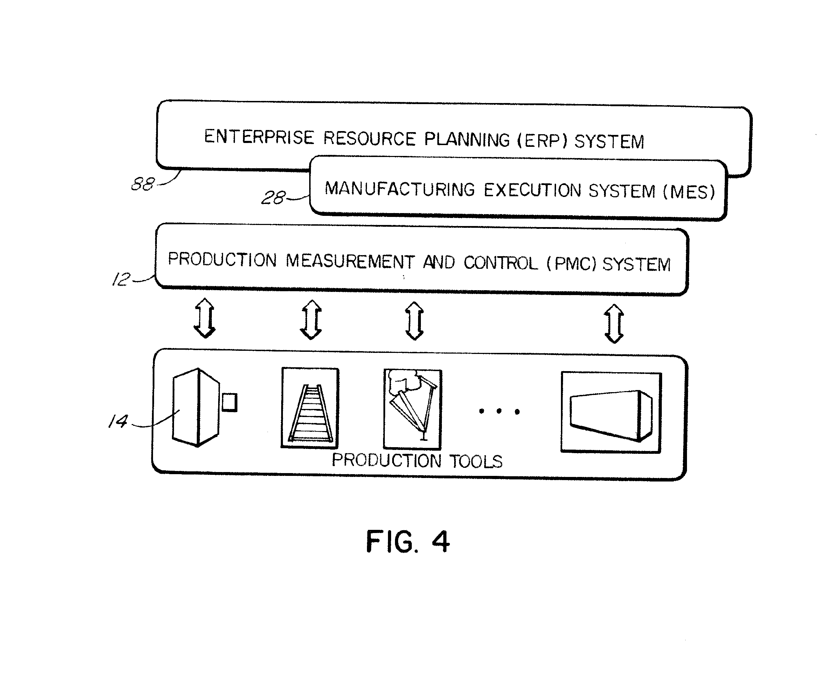

As seen in Figure 4, the PES System 12 fits between the production line(s) and the manufacturer's Manufacturing Execution System (MES) 28 and/or Enterprise Resource Planning (ERP) systems 88 to control production flow in a manner responsive to customer orders or other production targets. Working with the MES System 28 or ERP system 88 the PES System 12 can consolidate production data over time to support warranty provisions and administration, and aid in production and facility capital planning. It also complements the instrumentation of process tools by providing in-line metrics on WIP unit (wafers, cells, modules, etc; i.e. the workpiece) results, in contrast to tool operating parameters.

The networked nature of the PMC System 12 and MS Units 14 is inherently scalable. However, each MS Unit 14 itself should be configurable to allow for insertion in varying portions of the production line, and to support facility expansion. The MS Unit 14 hardware and software architecture to support this unit-level scalability is described below. In the PES System 10, the software architecture may also be designed for scalability - from interaction with a single PMC System 12 configured for "single-lane" operation to up to 50 MS Units 14 with multi-lane and line-switching capabilities.

## 2. Components and Features of the PES System

### PMC System architecture

One aspect of the invention provides a system in which multiple MS Units are placed between process tools in a manufacturer's production line, and a PMC System is networked to all those MS Units and (optionally) other third-party sensors and an ERP system. The architecture may also include the operational process software (software that links together the data from each MS Unit and makes factory-wide optimization decisions): the PMC System's integration of measurement data generated by the MS Units and third-party sensors, its use of this and other data to make factory-wide production flow control decisions, and the MS Units collective physical implementation of the PMC System's decisions on WIP units.

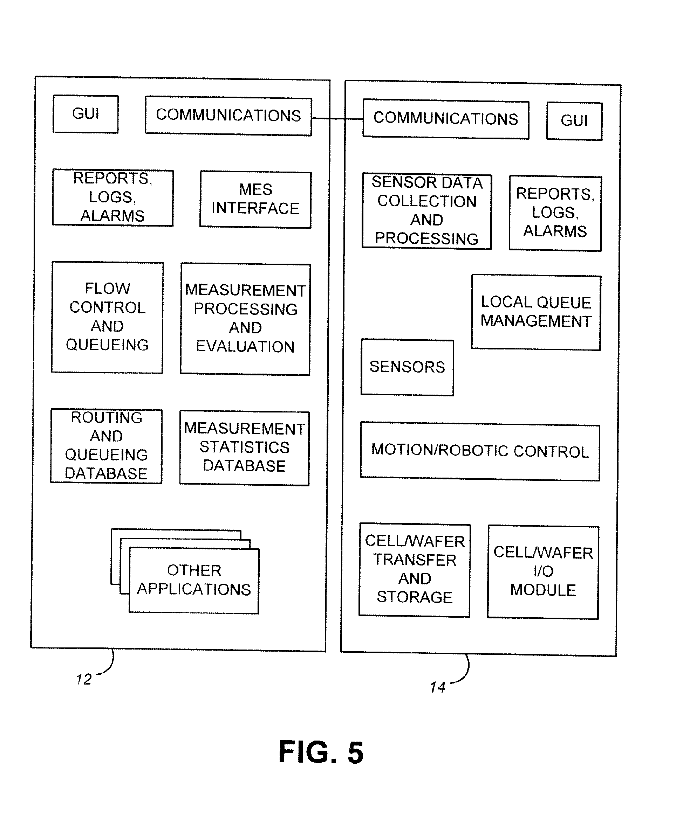

Referring to Figure 5, the internal functional architecture of the PMC System 12 and an MS Unit 14 is shown with each of their respective basic functional components shown schematically.

Closed-loop facility-wide inter-tool material handling

In contrast to other material handling systems, the PMC System of the present invention directs and implements the flow control of WIP units as a "gestalt" throughout the entire production facility. That is, the PMC System fully encompasses and integrates real-time measurement; in-line control decisions based on these measurements; and real-time WIP unit handling to implement these decisions. Within the scope of this invention each WIP unit is tracked, and WIP unit sequencing, routing, rejection and buffering decisions are made continuously in a discrete-time control process by considering the status of all WIP inventory in the system, simultaneously and in parallel. This can be implemented because the PES System is unique in providing the WIP unit measurement, facility-wide production controller and WIP unit handling and transfer capabilities that are specifically designed to work in concert, in real-time and with a stable control loop.

MS Unit architecture

As further provided within the scope of this invention, the Measurement/Handling MS Unit is a modular, configurable measurement and handling unit. Its unique design incorporates a configurable and scalable handling strategy. This provides for consistent handling throughout the manufacturing facility and cost-effective re-use of technology, even when individual MS Units are configured for different process tool interfaces and inspection tasks.

End-to-end WIP unit tracking

This feature of the present invention provides for the ability to uniquely identify and track individual cells, panels or modules - without the aid of special markings or tags - a unique capability enabled by the integrated real-time data management between the PMC System and all MS Units in a production facility, and the in-line measurement in each MS Unit. This tracking is done by either or both of:

a) Spatial tracking: The inherent knowledge of what WIP unit was picked up at a specific location and then placed at another specific location or buffered - by each MS Unit within its local workspace, and collectively by having all of the MS Units keep the PMC System informed of which WIP units they have in their workspace. A system-wide view is maintained in the PMC System of the location and state of all WIP units in production.

b) Measured characteristics: Each WIP unit's unique measured characteristics as it progresses through production (such as minor geometric variances, blemishes, characteristic response to luminescence tests, etc.) can be used to identify the unit.

c) Wafer edge coding: For silicon wafers, each unit can be coded on one or more locations around the perimeter of the wafer. The codes are a particular pattern of notches that uniquely identify the wafer within the line or facility. Because these notches are on the edge, rather than the surface of the wafers, they are expected to be highly resistant to the common problem of degradation or obscuring of surface markings as the wafer is processed into a cell. This resistance is enhancing by providing redundancy through the use of multiple coding locations on each wafer.

This tracking is necessary for implementation of the predictive WIP unit grading algorithm, and for WIP unit production flow queuing and sequencing/routing. If a facility implements all of its handling with MS Units, the exact location of each WIP unit in the production line(s) can be known at all times with just the spatial tracking. If there is uncertainty regarding the handling or if line operators make non-recorded interventions that change WIP unit locations, the measured characteristics method, or wafer edge coding method, or both, are recommended to be used - either with or without spatial tracking. Generally an approach using at least two of these methods in tandem is expected to be most robust.

Distributed WIP unit buffering

This feature of the present invention provides for the ability to hold or "buffer" WIP units at any MS Unit in the system. The method of physical implementation of this is described below. The method of buffering is centrally managed on a facility-wide basis from the PMC System. The purpose and use of WIP unit buffering is at least four-fold. First, buffered groups of WIP units are located at the MS Units for the purpose of substitution of "good" WIP when an opening is created in the production flow by the rejection of poor-grade WIP at that MS Unit. Second, faulty WIP is buffered to provide the ability to group it into "lots" for downstream mitigation of the faults. Third, WIP is buffered to also allow re-sequencing into lots that are based on business requirements. Finally, WIP is buffered to allow for a continuous flow of material through the line when individual process tools or material handling devices need to be taken off-line for scheduled maintenance or other reasons (including unscheduled shutdowns or errors).

At some steps in cell, module or panel production, WIP units may have a limited period of time in which they are usable for further processing. (Colloquially speaking, they can go "stale" if held in a buffered group too long at these stages). The WIP buffer management algorithm of the PMC System is designed to recognize this (based on data input from the manufacturer) and provides a "buffer refresh" capability that ensures that WIP units that are approaching their time limit for usability are cycled back into the manufacturing process and replaced with equivalent "fresh" WIP units.

The amount of WIP located at any given buffered group is determined by the following factors in combination:

1. The predicted rate of arrival of "good" WIP units at each buffering stage, as compared to the predicted arrival rate of WIP units that will be rejected. This is to ensure that there are sufficient "good" units to fill the "holes" created by removal of rejected WIP unit from the production flow.

2. The predicted incidence (number of WIP units per unit time) and occurrence intervals (the distribution - average frequency, variance and probability density function within the general flow of units) of WIP units with faults that can be mitigated by particular downstream adjustments to process tool recipes. Note that there may be many fault patterns that can be mitigated, and that mitigation for each of these fault patterns may differ, may involve recipe changes on one or more process tools, and - for mitigation involving more than one process tool - the recipe changes may be conditioned by WIP unit measurements taken after each mitigation step. The predicted incidences and occurrence intervals are derived by either a stochastic mathematical model, by past measured incidences and intervals, or both. These incidence and occurrence predictions are used to derive the number of buffer spaces (at any and each buffering stage) that need to be allocated to allow sufficient accumulation of each particular WIP unit type that suits mitigation with a matching downstream recipe change. "Sufficient" accumulation is that number of WIP units that can be grouped into a "lot" that is a best fit for the batch size (e.g. for a batch-oriented PVD tool) or economic period (e.g. temperature curve for a continuous-flow furnace or refill interval for silver paste in a metallization printer) of the required recipe change in the targeted process tool.

3. The need to ensure sufficient capacity of WIP units at each buffering stage to allow for re-sequencing of WIP units into lots based on customer orders or other business requirements. This grouping may be done over a series of (not necessarily consecutive) buffering stages. Therefore, the occurrence and lot size for each expected type of lot must be statistically modeled and correlated to the conformant WIP characteristics at each production stage where there is a buffering stage that provides for this. This can be done using either stochastic models, empirical data, or both.

4. The planned requirement to minimize line or facility shutdowns. This planning is done by developing a network queuing model of the line(s) and facility which accounts for the following:

   a. Individual throughput, latency and service (dwell) times for each tool, conveyor, storage unit (e.g. cassettes or stack boxes) and other devices in the facility.
   b. Planned maintenance intervals and durations for each tool in the facility
   c. The incidences (as random variables) of unplanned events that require shutdowns or slowdowns - both on a tool-by-tool basis, and for other causes (such as material unavailability)
   d. The location, latency and transfer rate for any intra- or inter-line handling systems (Handling/measurement units or other) in the facility
   e. Any other facility variables which affect line or tool availability, throughput, latency or service times

   5. The required refresh intervals for buffered WIP to ensure none "goes stale", conditioned by the arrival rate of new WIP and departure rate of old WIP; at each buffer stage as shown in the network queuing model.

Coordinated in-line inspection

In-line inspection is the act of inspecting every WIP unit during the production process, without removing the WIP units from the production flow. This feature of the present invention provides for coordinated in-line inspection by providing inspection undertaken by each MS Unit as they move WIP units from one stage in the production facility to the next. Additionally, the inspection algorithm is distributed and cumulative - meaning that each MS Unit can apply different sensors and sensor output processing to measure different characteristics of a particular WIP unit as it moves through production. The sum total of all of these diverse inspections, cumulatively, as they occur, can be used to grade or assess the WIP unit. The distributed and cumulative nature of the inspection process also provides a more cost-effective means to thoroughly measure and grade WIP units than traditional end-of-line grading and sorting.

Predictive WIP unit grading

A quality algorithm ("Quality Algorithm") determines at what final quality level a partially finished WIP unit is destined. ("quality" is a pre-defined function of the measured WIP unit features or attributes (defects or otherwise), conditioned by their relative importance, as specified by the customer). The algorithm relies on a feature correlation database that enumerates individual WIP unit features and their co-incidences at various points in the end-to-end fabrication process. The database must contain a statistically valid number of measurements (thousands of WIP units tracked through the process). By using the database, a WIP unit can be predictively graded at any point by comparing its features to the end result of other WIP units with statistically similar features at the same stage in fabrication. If the prediction falls within a user-defined confidence level, then, as described in the next paragraph, a decision can be made regarding sequencing (or line-switching) of the WIP unit, or even outright rejection from the production line(s). Repeating this process later in fabrication allows refinement of the grading and re-sequencing such that, ideally, all WIP units are ordered based on the desired production targets and precisely graded by the end of the line.

Dynamic conditioning of individual WIP handling

This feature of the present invention provides for the reduction of the incidence of damage or handling errors caused by the MS Unit (or any other handling device that can be interfaced to the PMC System). What is controlled, for every handling device in the system, is their WIP pick-up orientation, timing (approach, dwell and take-off) and forces (gripper-related, accelerative and jerk), transfer velocity, acceleration and jerk, and placement orientation, timing and forces, for each individual WIP unit. If a particular WIP unit is predicted to be impossible to handle without causing breakage or mis-handling that might require a system stoppage, it is flagged and ejected from the production line prior to an attempted pick-up.
The preferred way this is accomplished is as follows:

1. The PES System takes measurements of WIP units by in-line non-contacting measurement using infrared, optical, ultrasonic or electromagnetic techniques. Processing of the measurements includes a determination of any WIP unit faults (for each WIP unit uniquely) that may be exacerbated by downstream handling operations or that may cause the WIP unit to break or be mis-handled during downstream handling operations. This determination is part of the Quality Algorithm.
2. The above determination is weighted by the probability that such events (exacerbation of damage, breakage, or mis-handling) would occur for each WIP unit, the currently predicted grade of the WIP unit, and the (duration-weighted) current incidence of all types of faults of this nature.
3. If the weighted determination for a WIP unit exceeds a pre-set threshold for invoking changes in its downstream handling operations (to prevent mis-handling or damage), the PMC System notifies the relevant handling devices of the required changes, and also ensures that these are synchronized with the arrival of that particular WIP unit.
4. If such changes (either per WIP unit or over a series of WIP units, not necessarily consecutively) create one or more "holes" (a time and space opening in the production flow that can be made equal to an integer number of WIP units), then one or more MS Units with buffered good WIP may be directed to fill the hole(s).
5. If the weighted determination for a WIP unit exceeds a pre-set threshold for the likelihood that the WIP would be broken during handling or mis-handled sufficiently to require a stoppage of the handling device, then instead of the actions above, the PMC System would either notify the operator (identifying the particular WIP unit in question), or direct machinery in the production line to remove the WIP unit from the line prior to the next handling operation.
6. If a WIP unit is removed by machinery, a MS Unit that has good WIP buffered can be notified of the location of the resulting "hole" in the production flow, and directed to fill the hole from its source of buffered WIP. If it is removed manually, the operator may provide this information, or it may be discerned when it is noticed to be missing at the next measurement device.

In summary, if the system observes a wafer or cell that is going to break downstream, the system directs the next robot downstream to handle it carefully or reject the cell and replace it with good WIP. This comprises feed-forward adjustment of handling to minimize breakage or eliminate cells that will fail. This is all designed to improve cell production line performance and reduce the cost of unnecessarily processing cells that would break with downstream processing.

WIP unit sequencing and routing algorithm

This algorithm is a further feature of the present invention that works in tandem with the Quality Algorithm and WIP unit tracking capabilities to enable the grouping of WIP units in like categories or grades throughout the production facility. On a facility-wide level the algorithm coordinates the MS Units to act as a network of routers - buffering WIP units, switching WIP units between lines and (re) sequencing and routing WIP units to achieve the desired output lot size and consistency to facilitate downstream processing or customer order management (as specified by ERP input). It can also implement goal-seeking measures - most notably DRT, described below. Multi-line WIP routing is illustrated below.

Dynamic Rejection Threshold (DRT)

This feature of the present invention provides for automatic continuous adjustment of the quality threshold at which WIP units are deemed "scrap", in order to maximize the factory's economic output. At a given point in time, an adjustment decision is made based on a predictive measure of the cumulative value of all WIP units in the production line(s), compared against the cost of scrapped WIP units. The rejection threshold is set to maximize the cost-benefit equation (subject to some constraints that can be set by the operator). The unique DRT feature is enabled by the PMC System's ability to consolidate and process real-time measurements from all MS Units in a production facility.

True Production Measurement (TPM)

By comprehensively measuring the quality of WIP units not just at the "end of the line", but also at the outputs of the individual processes during their fabrication, the PES System builds and maintains a production performance database that can be uniquely used to monitor, analyze and report on the performance of each tool, tool group (i.e. portion of the fabrication process), and the overall production facility. This may be used for the following purposes:

- Process tool performance verification. Measurement of the attributes of WIP units output from a particular process tool to verify it's conformance to production specifications, independently of the tool's less direct instrumentation. This can be performed for individual tools, and also for chains or networks of tools, providing a means to verify sub-systems or entire lines provided by system integrators or turnkey suppliers.
- Process tool performance monitoring and trend capture. This can be used for a variety of pre-emptive as well as scheduled maintenance activities.
- Production material supply and cost optimization. Evaluation of the effect of feedstock quality and/or process recipes on measured WIP unit quality, at any stage in production. This can be used to determine and (if desired) dynamically vary the optimal combination of raw material and consumables for required facility output.

**3. Functional and System Architecture**

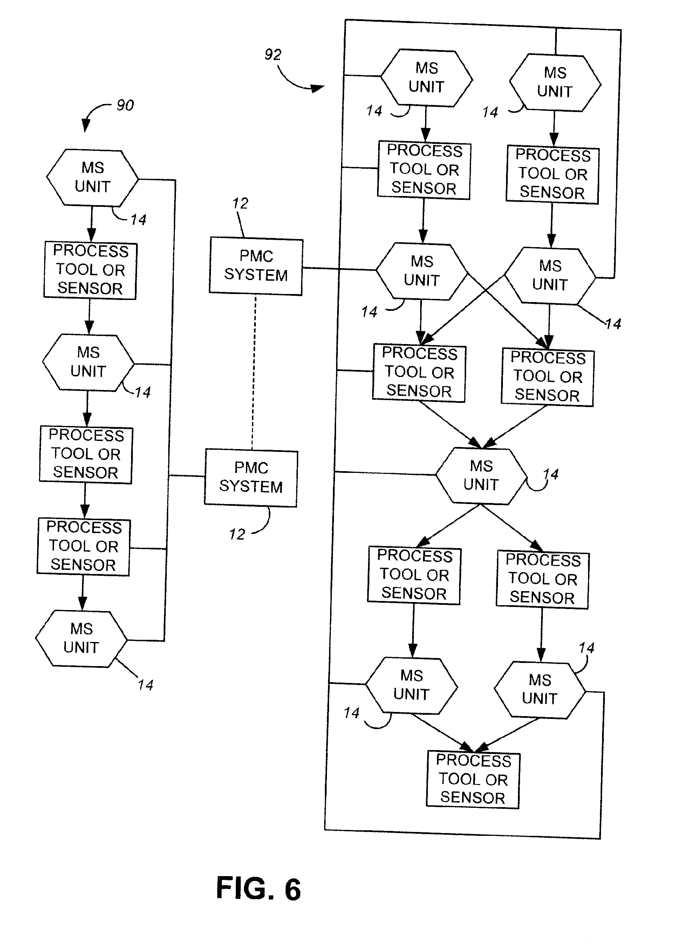

As shown in Figure 6, In a preferred form, the system layouts or architectures in a production facility may be configured in a number of arrangements and configurations as follows:

- Linear arrangement 90 of MS Units 14 in a single-line production facility, with no integration to other tools or sensors. The MS Units 14 may be placed in between process tools and/or other automation devices. No sensors or actuators need be interfaced to the PMC System 12 other than the MS Units 14 and the manufacturer's ERP and/or MES system(s) (see Figure 4).

- The same linear arrangement as above, in a single-line facility, but including with other equipment and/or sensors integrated to the PMC System 12. This can require additional features for the communication interfaces to the other equipment and the required data recognition and processing in the PMC System 12.

- Matrixed arrangement 92 of MS Units 14 in a multi-line production facility. In this case, the MS Units 14 can be used to route WIP units between lines, based on a need for specialized processing, load control, optimal use of process tools to produce a specific Q factor for a WIP unit, or other considerations determined by the manufacturer. The parameters and rules for these routing decisions are largely (but not entirely) embodied in the PMC System's Quality and WIP unit sequencing and routing algorithms. As for the linear arrangements 90, this matrixed arrangement 92 can be set up with interfaces to the MS Units 14 only, or to other sensors and equipment as well.

The linear and matrixed archetypes can be deployed independently or in combination in one or more manufacturing facilities. Multiple PMC Systems may be installed to support these configurations. Examples of these archetypes are shown (combined) in Figure 6. Note that WIP unit flow is shown with arrows, control interfaces with a solid line and optional interface between two PMC Systems 12 with a dashed line.

4. **PMC System**

The PMC System consolidates and inter-relates measurements from sensors located in various MS Units and may also be attached to other devices and systems in a particular unit manufacturing facility. It uses this information to direct the actions of the MS Units. As such, it is a facility-wide controller for managing aspects of the WIP unit flow through the facility.

***Product Components***

Preferably an PMC System is comprised of the following major elements:

**Hardware**

- An ***industrial computer***, available in a variety of configurations to provide sufficient hard disk storage, processing capacity, communication interfaces and redundancy (for our high availability option). This computer may be available as a standard rack-mount unit and will be configured as a closed unit -

• An *operator interface kit* (keyboard, display, mouse and lock-out switch)
• Optional *storage expansion units* - regular or RAID hard disk storage to support larger systems or on-line backup.

## Software

Two categories of software may form part of the PMC System. One category is standard third party software - most importantly the operating system and the database management system. The other category encompasses all proprietary software of the applicant required to program, configure, operate, administer and maintain the product.

Both the third party and applicant proprietary software may be provided to the customer as a single distribution (pre-loaded on the PMC System computer and as a backup DVD-ROM).

In a preferred form the applicant proprietary software comprises the following elements:

• *WIP unit tracking* - the system-wide database of all WIP units' location and state.
• *WIP unit sequencing and routing* - the database and algorithm to determine optimal WIP unit sequencing and flow through the facility, plus the capability to command the **MS Units** as a network of actuators to implement the buffering, sequencing and switching required to implement the flow control.
• *TPM dashboard* - reports, notifications and alarm management and operation for True Production Measurement.
• *Measurement processing and evaluation* - the system-wide consolidation of all measurements, and comparison to the statistical database to support and implement the Quality Algorithm, DRT and dynamic conditioning of individual WIP handling features and the TPM dashboard.
• *Dynamic conditioning of individual WIP handling* - as described above.

Standard third-party software includes:

• *Operating System*. PMC System uses Microsoft's Windows operating system. To provide a stable and predictable operating environment, direct Internet access and automatic updates are disabled.
• *DBMS*. PMC System uses a standard "off-the-shelf" Database Management System providing very high performance read-write access.
• *Operations, Administration, Maintenance and Provisioning*. This provides local capabilities for control of run-time operation, diagnostics, operational logs, alarms, event trapping, maintenance procedures and configuration (including software updates). It also includes the capability for remote OAM&P operations with MS Units, including the downloading of updates, patches, configuration data, etc.
• *ERPIMES interface*
• *Soft PLC*. For facility environments that require it, the PMC System provides an IEC 61131 Rockwell-compatible interface.

### Operational Flow

A high-level operational flow of the PMC System is shown in Figure 7. Note that this flowchart does not include system maintenance, administration, and provisioning operations.

The PMC System provides discrete feedback control for the flow of WIP units through the PV manufacturing facility. For each discrete time slice (or system "clock tick") the PMC System receives information from all of the MS Units in a facility, plus measurements from any third-party devices (such as process tools) that are networked to it. Each WIP unit is uniquely identified by a tracking methodology.

The measurements pertaining to each WIP unit are added to a record, kept by the PMC System, which aggregates all of the measurements taken for that WIP unit as it progresses through the production process. Part of this record is also a "quality factor" (Q) for each WIP unit that (as an example in the case of c-Si cells) is a function of the following:

• Aesthetic measures such as (but not restricted to) edge smoothness (or cracking), AR coating uniformity, metallization (busbar) straightness, etc.
• Geometric measures such as (but not restricted to) conformance to target shape, edge regularity, bowing/warping, etc.
• Photo-electrical measures such as (but not restricted to) I-V curve conformance, total Wp output, reverse bias leakage current, etc.
• Other measures as determined by the manufacturer

At any stage in the fabrication of a WIP unit, its quality factor is a predictive estimate based on incomplete information. A WIP unit's quality factor is determined using the Quality algorithm, and takes the general form:

$$Q = f(A, G, E, D)$$

where **A** is aesthetics, **G** is geometry, **E** is photo-electrical and **D** is defect.

Part of the process of determining the Q for a given WIP unit is the use of the defect correlation database to assess images of the WIP unit against known defects and determine the degree to which the WIP units have such defects. The closer the observed defects are in the WIP units to the stored defects, the closer D is to 100%. The closer the color image is to the desired color image, the closer A is to 100%. The closer the WIP unit geometry is to the target geometry, the closer G is to 100%. The closer the electrical performance is to the desired electrical performance, the closer E is to 100 %.

The measurement results are also added to a database that tracks the results for each stage of the production process (the True Production Measurement Database). This database can be queried (and logs and alarms set) for the purposes of implementing the TPM feature, as described herein.

Once all of the WIP units have had their **Q** factor updated, they are assigned updated gradings, as defined by the customer. After this, the DRT algorithm (as described above) is invoked to update the quality threshold $Q_T$ below which WIP units are rejected. Then the optimal facility-wide WIP unit ordering, (more specifically WIP unit sequencing - and routing, if multiple production lines exist in the facility) is determined, and the PMC System calculates and sends the specific WIP unit transfer, line switching, buffering and rejection instructions needed, to each MS Units to enact this sequencing and routing.

### 5. **MS Units**

In accordance with the present invention, the Measurement MS Unit is a measurement device, and the Measurement/Handling MS Unit is a combined handling and measurement device. MS Units are placed between process tools to measure and/or effect the flow of WIP units through the PV manufacturing facility. MS Units may be placed singly or in parallel between tools.

### *Product Components*

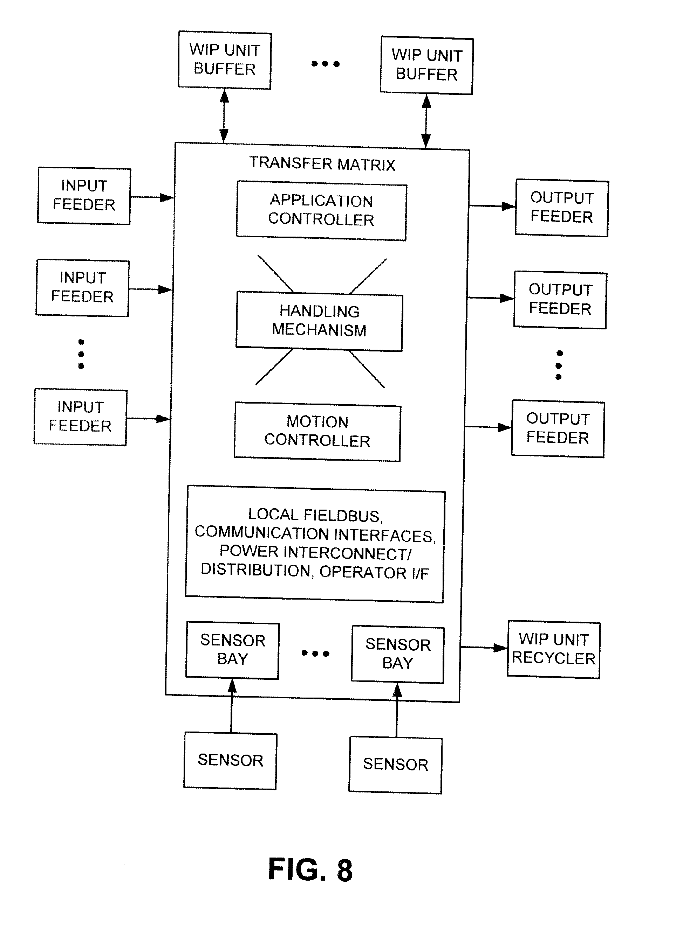

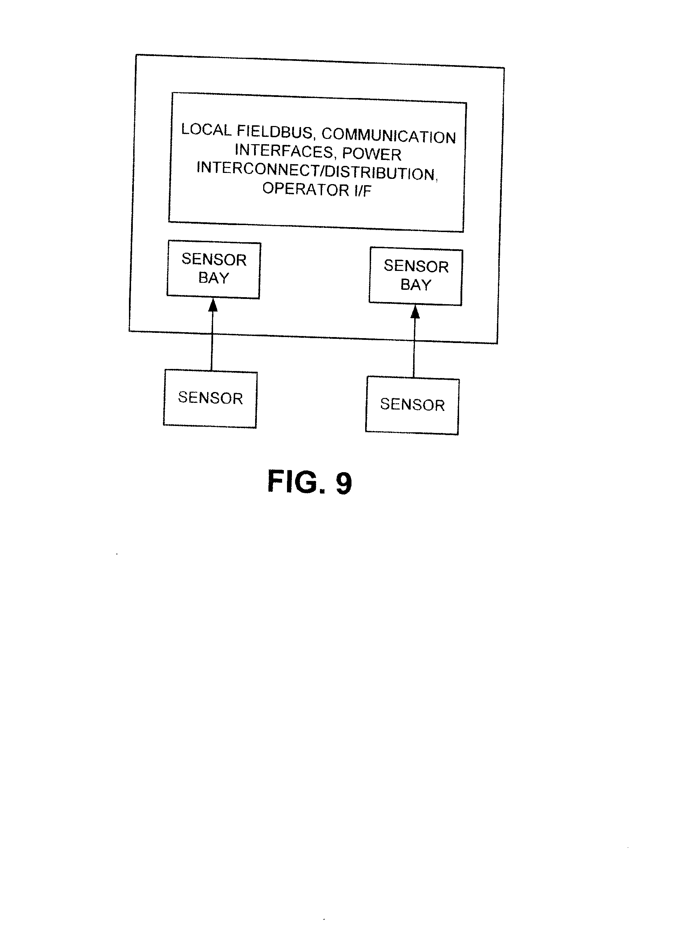

MS Units are placed between process tools to measure and/or effect the flow of WIP units through the PV manufacturing facility. MS Units may be placed singly or in parallel between tools. Measurement/Handling MS Unit hardware architecture is depicted in Figure 8. And Measurement MS Unit hardware architecture in Figure 9. MS Unit operational flow is depicted in Figure 10.

MS Units are comprised of some or all of the following major elements:

- A *TransferMatrix,* which comprises ...

  ○ A high speed handling mechanism (nominally a "pick and place" manipulator with a Bernoulli or suction gripper) with a working area enabling reach to all peripherals
  ○ A motion controller for real-time control of all mechanisms and synchronization of sensor operation
  ○ An application controller

  ○ Local fieldbus and system-wide communication network interfaces
  ○ Master power interconnect and distribution to peripherals
  ○ Operator interface kit (keyboard, display, status lamps, e-stop, lock-out switch)
  ○ Specialized bays for peripherals (sensor bays, WIP unit buffer bays, input and output feeder bays, recycler bay)

  all within a standardized equipment frame. It may also use vision-guided motion control for locating and placing WIP units. The Transfer Matrix bays will initially support one sensor, two WIP unit buffers, one input feeder, one output feeder and one WIP unit recycler.

- One or more *Input Feeders* and one or more *Output Feeders*. Input feeders accept WIP units from a process tool (such as a PECVD machine or etcher) and feed the WIP units into the Transfer Matrix in an ordered fashion. Conversely, output feeders accept WIP units from the Transfer Matrix and provide them to a process tool, again in an ordered fashion. Each feeder mates with the Transfer Matrix via a feeder equipment bay, and is controlled from the motion and application controllers on the core. Power is also distributed to each feeder by the core. Feeders are semi-custom devices, as they must interface to a variety of process tools from different manufacturers in facility-specific configurations. It is expected that, over time, we will develop a "library" of standard feeders for process tools from the major suppliers, however it is likely that some degree of configuration will always be required for particular customer installations.

- One or more *Sensors*. Initially the sensors will be machine-vision based devices designed to check for surface features or flaws (such as texture, metallization alignment/conformity, micro-cracks, fingerprints, edge or metallization irregularities) or 3D irregularities (bowing, warping or surface flaws). Other sensors may be added over time, such as electroluminescence or photoluminescence sensors, I-V testers, sensors for P-N junction and metallization profiles, coating profiles and spectrographic behaviour, sensors to measure mass changes due to doping, etching or metallization and sensors to measure a variety of other electrical characteristics such as (but not limited to) resistivity, sheet resistance, diffused dopant concentration and reverse-bias impedance. Different types of sensors will be used at different points in the end-to-end fabrication process, therefore in a Handling/measurement unit, each sensor mates with the Transfer Matrix via a sensor equipment bay, and is controlled from the motion and application controllers on the core. Power is also distributed to each sensor by the core.

- One or more **WIP unit Buffers**. These are random-access WIP unit storage devices that are used to buffer WIP units for the purposes of WIP unit sorting, production throughput control, WIP unit re-sequencing or WIP substitution. A buffer contains mechanisms enabling it to present or accept WIP units at random from the Transfer Matrix and maintain an index of WIP units for unique identification and tracking. Each WIP unit buffer mates with the Transfer Matrix via a buffer equipment bay, and is controlled from the motion and application controllers on the core. Power is also distributed to each WIP unit buffer by the core.

- One **WIP Unit Recycler**. This is a scrap holder (for WIP units that the PES System directs to be rejected from further fabrication) that attaches to the core via the recycler bay. Like the other peripherals, this is controlled and powered from the core.

## ALTERNATIVES

Computer program elements of the invention may be embodied in hardware and/or in software (including firmware, resident software, micro-code, etc.). It may take the form of a computer program product, that can be embodied by a computer-usable or computer-readable storage medium having computer-usable or computer-readable program instructions, "code" or a "computer program" embodied in the medium for use by or in connection with the system of the present invention. In the context of this application, a computer-usable or computer-readable medium may be any medium that can contain, store, communicate, propagate, or transport the program for use by or in connection with the instruction execution system, apparatus, or device. The computer-usable or computer-readable medium may be, for example but not limited to, an electronic, magnetic, optical, electromagnetic, infrared, or semiconductor system, apparatus, device, or propagation medium such as the Internet. Note that the computer-usable or computer-readable medium could even be paper or another suitable medium, upon which the program is printed, as the program can be electronically captured, via, for instance, optical scanning of the paper or other medium, then compiled, interpreted, or otherwise processed in a suitable manner. The computer program product and any software and hardware described herein form the various means for carrying out the functions of the invention in the example embodiments. Also, while software in the memory or in some other memory of the computer and/or server may be used to allow the system to carry out the functions and features described herein in accordance with the preferred embodiment of the invention, such functions and features also could be carried out via dedicated hardware, firmware, software, or combinations thereof, without departing from the scope of the invention.

Although the invention has been shown and described with respect to a certain preferred embodiment or embodiments, it is obvious that equivalent alterations and modifications will occur to others skilled in the art upon the reading and understanding of this specification and the annexed figures. For example, regard to the various functions performed by the above described elements (components, assemblies, devices, software, computer programs, etc.), the terms (including a reference to a "means") used to describe such elements are intended to correspond, unless otherwise indicated, to any element that performs the specified function of the described element (i.e., that is functionally equivalent), even though not structurally equivalent to the disclosed structure that performs the function in the herein illustrated exemplary embodiment or embodiments of the invention. In addition, while a particular feature of the invention may have been described above with respect to only one or more of several illustrated embodiments, such feature may be combined with one or more other features of the other embodiments, as may be desired and advantageous for any given or particular application.

Preferred embodiments of the invention are as defined in the following points:

1. A method of manufacturing photovoltaic products in a manufacturing production line of a series of production steps, comprising, at each of a plurality of intermediate production steps of the production line:

(a) assessing each photovoltaic product for suitability based on predetermined criteria for a preferred product, to obtain real time assessment results for the product at each production step;

(b) storing the assessment results for that product by production step, in a memory;

(c) assigning a grade to each photovoltaic product, based on either:

(i) the assessment results for that product at that step;

(ii) a comparison of the assessment results for that product at that step to statistical analysis of assessment results of previously processed photovoltaic products at that step; or

(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;

(d) storing the grade for that product at such production step, in a memory; and

(e) using the grade to determine when and how the product is processed through downstream production steps.

2. The method as described in point 1 further comprising:

(f) associating all of the products in the production line at a particular step, having the same stored grade, together in a group for further processing as a group.

3. The method as described in point 2 further comprising:

(g) for groups having grades indicative of products outside of the predetermined tolerances, adjusting the downstream production equipment of the production line to process each such group of products with the same grade so as to bring the group within the predetermined tolerances; and

(h) processing the group together using the downstream production equipment as adjusted at step (g), to bring the products of the group within the predetermined tolerances.

4. The method as described in point 2 wherein steps (a) to (e) are performed at every intermediate production step of the production line to obtain a grade for each product at every production step of the production line and wherein step (f) is performed at each one of those steps.

5. The method as described in point 3 wherein the grade assignable to a product at a production step is associated with information for adjusting the downstream production equipment at step (g) so as to bring the group associated with the grade within the predetermined tolerances and wherein the downstream production equipment is adjusted accordingly for processing of that group.

6. The method as described in point 2 wherein if groups at a step are identified as outside of the predetermined tolerances, process changes are made upstream of the step to production equipment to bring future products produced within the predetermined tolerances.

7. The method as described in point 2 wherein groups identified as outside of the predetermined tolerances at a step are prioritised for further processing after groups at that step which are within the predetermined tolerances.

8. The method as described in point 7 wherein groups at a step are prioritised for further processing based on the grade of the group, with groups of grades having more significant deviations from the predetermined tolerances positioned for processing behind groups with grades representing lesser deviations from the predetermined tolerances.

9. A method of controlling a series of production steps in a manufacturing production line for the manufacture of photovoltaic products, comprising the steps of:

(a) at predetermined production steps, receiving grading information associated with a photovoltaic product in the production line at that step,

(b) using the grading information to allocate a grade to the product, the grade indicative of whether the product is within predetermined tolerances for that step;

(c) comparing, by a processor, said grade to a plurality of grades of other previously processed photovoltaic products in a knowledge base stored in a memory, to identify a similar grade, the similar grade being a grade associated with previous products having similar grading information, wherein said knowledge base further comprises information as to the outcome of the grade at further process steps in the line and wherein said knowledge base further comprises production line adjustment information which bring the similar grade products to an acceptable tolerance;

(d) based on the outcome information of the similar grade, determining a predicted outcome of the photovoltaic product at one or more further processing steps in the production line; and

(e) if the predicted outcome is outside of the predetermined tolerance at a further processing step, providing the production line adjustment information for that step to adjust the production line to process the product.

10. The method as described in point 9 wherein at step (e):

(a) if the predicted outcome is outside of the predetermined tolerance at a further processing step, storing the product in a product group of products with the same or similar grades until a predetermined number of products are stored;

(b) providing the production line adjustment information for that step to adjust the production line prior to processing the products as a group; and

(c) inserting the product group after the adjustments are made and processing them as a group to achieve the desired performance tolerances.

11. The method as described in point 9 wherein the grading information is based on either:

(a) the assessment results for that product at that step;

(b) statistical analysis of assessment results of previously processed photovoltaic products at that step; or

(c) a comparison of cumulative historical assessment results for the product throughout its past production steps in comparison to a statistical analysis of historical cumulative assessment results of previously processed photovoltaic products over the same production steps.

12. A method of controlling a series of production steps in a manufacturing production line for the manufacture of photovoltaic products, comprising the steps of:

(a) logging past assessments of a plurality of photovoltaic products at predetermined production steps in a knowledge base stored in a memory, each assessment determined by past processing of photovoltaic products;

(b) logging past courses of action taken at the production steps in response to said past assessments, and associated outcomes, in said knowledge base;

(c) characterizing at least one of said associated outcomes as a positive outcome;

(d) receiving a real-time assessment of a photovoltaic product at a production step;

(e) comparing, by a processor, said real-time assessment to said past assessments to determine a predicted assessment for said product;

and

(f) providing one of said courses of action associated with said positive outcome as the course of action to take in further processing of the product.

13. The method as described in point 12 wherein at the comparison step, the real-time assessment is compared to said past assessments at that step.

14. The method as described in point 12 wherein at the comparison step, the real-time assessment is associated with past assessments of the product at the production step and a predetermined number of past production steps compared to said past assessments at that step and the predetermined number of past production steps.

15. The method as described in point 12 further comprising:

(g) receiving the outcome of the photovoltaic product after the further processing;

(h) determining whether the outcome is a positive outcome; and

(i) if the outcome is a positive outcome, logging the real time assessment and the course of action of the photovoltaic product in said knowledge base as a part of the past assessments, past courses of action, and associated outcomes.

16. The method as described in point 12 further comprising:

(a) at step (a), logging past damage assessments of the plurality of photovoltaic products at predetermined production steps in a knowledge base stored in a memory, each damage assessment determined by past processing of photovoltaic products;

(b) at step (b), assigning a damage severity threshold based on the damage assessments of past photovoltaic products that cause impairment of the manufacturing production line at a production step, stored in said knowledge base;

(c) at step (d), receiving a real time damage assessment of a photovoltaic product at the production step;

(d) comparing, by a processor, said real-time damage assessment to said damage severity threshold to determine whether said product is at risk of impairing the manufacturing production line; and

(e) if such product is determined to be at risk of impairing the manufacturing production line, providing removal instructions for removing said product from the production line before the next production step.

17. The method as described in point 16 wherein together with said removal instructions providing instructions to replace the product to be removed with instructions to replace the product with another product at that production step determined by its damage severity threshold to not be at risk of impairing the manufacturing production line at that production step.

18. An apparatus comprising a processing device; a computer readable medium tangibly embodying a computer program product for manufacturing photovoltaic products, the computer program product comprises instructions for causing a processor to:

(a) assess each photovoltaic product for suitability based on predetermined criteria for a preferred product, to obtain assessment results for the product at each production step;

(b) store the assessment results for that product by production step, in a memory;

(c) assign a grade to each photovoltaic product, based on either:

(i) the assessment results for that product at that step;

(ii) a comparison of the assessment results for that product at that step to statistical analysis of assessment results of previously processed photovoltaic products at that step; or

(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;

(d) store the grade for that product at such production step, in a memory; and

(e) use the grade to determine when and how the product is processed through downstream production steps.

19. An apparatus for manufacturing photovoltaic products comprising:

(a) circuitry for assessing each photovoltaic product for suitability based on predetermined criteria for a preferred product, to obtain assessment results for the product at each production step;

(b) circuitry for storing the assessment results for that product by production step, in a memory;

(c) circuitry for assigning a grade to each photovoltaic product, based on either:

(i) the assessment results for that product at that step;

(ii) a comparison of the assessment results for that product at that step to statistical analysis of assessment results of previously processed photovoltaic products at that step; or

(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;

(d) circuitry for storing the grade for that product at such production step, in a memory; and

(e) circuitry for using the grade to determine when and how the product is processed through downstream production steps.

20. The apparatus as described in point 19 further comprising:

(f) circuitry for receiving the outcome of the photovoltaic product after the further processing;

(g) circuitry for determining whether the outcome is a positive outcome; and

(h) circuitry logging the real time assessment and the course of action of the photovoltaic product in said knowledge base as a part of the past assessments and associated past courses of action, if the outcome is a positive outcome.

21. A computer system comprising a memory having stored therein a photovoltaic products manufacturing control application for a manufacturing production line of a series of production steps; and a processor coupled to the memory, wherein the execution of said manufacturing control application generates a method comprising:

(a) assessing each photovoltaic product for suitability based on predetermined criteria for a preferred product, to obtain assessment results for the product at each production step;

(b) storing the assessment results for that product by production step, in a memory;

(c) assigning a grade to each photovoltaic product, based on either:

(i) the assessment results for that product at that step;

(ii) a comparison of the assessment results for that product at that step to statistical analysis of assessment results of previously processed photovoltaic products at that step; or

(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;

(d) storing the grade for that product at such production step, in a memory; and

(e) using the grade to determine when and how the product is processed through downstream production steps.

22. The system as described in point 21 wherein the execution of the application further generates a method comprising:

(f) associating all of the products in the production line at a particular step, having the same stored grade, together in a group for further processing as a group.

23. The system as described in point 1 further comprising the step of:

(f) using the grade at an intermediate step together with one or both of:

(i) the final performance of the product; and
(ii) the final physical attributes of the product;

to establish a causal relationship between one or both of them and the grade at the intermediate step.

**Claims**

1. A method of manufacturing photovoltaic products in a manufacturing production line (32) of a series of production steps (38, 42, 46, 50, 54, 58, 62, 66, 68), comprising, at each of a predetermined plurality of intermediate production steps of the production line (32):

(a) assessing each photovoltaic product for suitability based on predetermined criteria for a preferred product, to obtain real time assessment results for the product at each production step;
(b) storing the assessment results for that product by production step, in a memory (12);
(c) assigning a grade to each photovoltaic product, based on either:

(i) the assessment results for that product at that step;
(ii) a comparison of the assessment results for that product at that step to statistical analysis of assessment results of previously processed photovoltaic products at that step; or
(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;
(d) storing the grade for that product at such production step, in a memory (12); and

(e) using the grade to determine when and how the product is processed through downstream production steps.

2. The method of claim 1 further comprising:

(f) associating all of the products in the production line (32) at a particular step, having the same stored grade, together in a group for further processing as a group.

3. The method of claim 2 further comprising:

(g) for groups having grades indicative of products outside of the predetermined tolerances, adjusting the downstream production equipment of the production line (32) to process each such group of products with the same grade so as to bring the group within the predetermined tolerances; and
(h) processing the group together using the downstream production equipment as adjusted at step (g), to bring the products of the group within the predetermined tolerances.

4. The method of claim 3 wherein the grade assignable to a product at a production step is associated with information for adjusting the downstream production equipment at step (g) so as to bring the group associated with the grade within the predetermined tolerances and wherein the downstream production equipment is adjusted accordingly for processing of that group.

5. The method of claim 2 wherein if groups at a step are identified as outside of the predetermined tolerances, process changes are made upstream of the step to production equipment to bring future products produced within the predetermined tolerances.

6. The method of claim 2 wherein groups identified as outside of the predetermined tolerances at a step are prioritised for further processing after groups at that step which are within the predetermined tolerances.

7. The method of claim 6 wherein groups at a step are prioritised for further processing based on the grade of the group, with groups of grades having more significant deviations from the predetermined tolerances positioned for processing behind groups with grades representing lesser deviations from the predetermined tolerances.

8. The method of claim 1, wherein step (e) comprises the steps of:

(a) comparing, by a processor (12), said grade to a plurality of grades of other previously processed photovoltaic products in a knowledge base stored in a memory (12), to identify a similar grade, the similar grade being a grade associated with previous products having similar grading information, wherein said knowledge base further comprises information as to the outcome of the grade at further production steps in the line and wherein said knowledge base further comprises production line adjustment information which bring the similar grade products to an acceptable tolerance;
(b) based on the outcome information of the similar grade, determining a predicted outcome of the photovoltaic product at one or more further production steps in the production line (32); and
(c) if the predicted outcome is outside of the predetermined tolerance at a further production step, providing the production line (32) adjustment information for that further production step to adjust the production line (32) to process the product.

9. The method of claim 8 wherein at step (c):

(a) if the predicted outcome is outside of the predetermined tolerance at a further production step, storing the product in a product group of products with the same or similar grades until a predetermined number of products are stored;
(b) providing the production line (32) adjustment information for that step to adjust the production line (32) prior to processing the products as a group; and
(c) inserting the product group after the adjustments are made and processing them as a group to achieve the desired performance tolerances.

10. The method of claim 8 wherein the grading information is based on either:

(a) the assessment results for that product at that step;
(b) statistical analysis of assessment results of previously processed photovoltaic products at that step; or
(c) a comparison of cumulative historical assessment results for the product throughout its past production steps in comparison to a statistical analysis of historical cumulative assessment results of previously processed photovoltaic products over the same production steps.

11. The method of claim 1, wherein step (e) comprises the steps of:

(a) logging past assessments of a plurality of photovoltaic products at predetermined production steps in a knowledge base stored in a memory (12), each assessment determined by past processing of photovoltaic products;

(b) logging past courses of action taken at the production steps in response to said past assessments, and associated outcomes, in said knowledge base;

(c) characterizing at least one of said associated outcomes as a positive outcome;

(d) comparing, by a processor, the grade of the photovoltaic product at a production step to said past assessments to determine a predicted assessment for said product; and

(e) providing one of said courses of action associated with said positive outcome as the course of action to take in further processing of the product.

12. A computer program adapted to perform the method of claim 1.

13. An apparatus adapted to manufacture photovoltaic products comprising:

(a) circuitry (14) adapted to assess each photovoltaic product for suitability based on predetermined criteria for a preferred product, to obtain assessment results for the product at each production step;

(b) circuitry (12) adapted to store the assessment results for that product by production step, in a memory (12);

(c) circuitry (12) adapted to assign a grade to each photovoltaic product, based on either:

(i) the assessment results for that product at that step;

(ii) a comparison of the assessment results for that product at that step to statistical analysis of assessment results of previously processed photovoltaic products at that step; or

(iii) a comparison of cumulative historical assessment results for the product at past production steps to a statistical analysis of historical cumulative assessment results of previously processed photovoltaic products over the same production steps;

at each such production step, the grade identifying whether the product is within or outside of predetermined tolerances, representing deviations from the predetermined criteria, for photovoltaic products at such step;

(d) circuitry (12) adapted to store the grade for that product at such production step, in a memory; and

(e) circuitry (12) adapted to use the grade to determine when and how the product is processed through downstream production steps.

14. A data processing apparatus comprising means for carrying out the method of claim 1.

15. The data processing apparatus of claim 14 wherein the apparatus further comprises means for carrying out a method comprising:

(f) associating all of the products in the production line (32) at a particular step, having the same stored grade, together in a group for further processing as a group.

**Patentansprüche**

1. Verfahren zur Herstellung von Photovoltaik-Produkten in einer Fertigungsproduktionslinie (32) von einer Reihe von Herstellungsschritten (38, 42, 46, 50, 54, 58, 62, 66, 68), an jedem von einer vorgegebenen Vielzahl an Zwischenherstellungsschritten der Produktionslinie (32) umfassend:

a) Bewerten jedes Photovoltaik-Produkts auf Eignung anhand vorgegebener Kriterien für ein bevorzugtes Produkt, um Echtzeitbewertungsergebnisse für das Produkt an jedem Produktionsschritt zu erhalten;

b) Speichern der Bewertungsergebnisse für das Produkt mittels Produktionsschritt in einem Speicher (12);

c) Zuordnen eines Grades für jedes Photovoltaik-Produkt auf Grund entweder:

i) der Bewertungsergebnisse für das Produkt an diesem Schritt;

ii) eines Vergleichs von Bewertungsergebnissen für das Produkt an diesem Schritt mit einer statistischen Auswertung von Bewertungsergebnissen von zuvor verarbeiteten Photovoltaik-Produkten an diesem Schritt; oder

iii) eines Vergleichs von kumulierten bisherigen Bewertungsergebnisse für das Produkt an früheren Produktionsschritten mit einer statistischen Auswertung von kumulierten bisherigen Bewertungsergebnisse von zuvor verarbeitete Photovoltaik-Produkte über die gleichen Produktionsschritte hinweg;

an jeden solchen Produktionsschritt repräsentiert der Grad, welcher kennzeichnet ob das Produkt sich innerhalb oder außerhalb von vorgegebenen Toleranzen befindet, Abweichungen von den vorgegebenen Kriterien für Photovoltaik-Produkten für diesen Schritt;

d) Speichern des Grades für dieses Produkt an diesen Produktionsschritt in einem Speicher (12); und

e) Verwenden des Grades, um zu bestimmen wann und wie das Produkt durch die nachgeschalteten Produktionsschritte verarbeitet wird.

2. Verfahren nach Anspruch 1 weiter umfassend:

f) Verbinden all jener Produkte in der Produktionslinie (32) an einem bestimmten Schritt, die den ähnlichen gespeicherten Grad aufweisen, zusammen in eine Gruppe zur weiteren Verarbeitung als eine Gruppe.

3. Verfahren nach Anspruch 2 weiter umfassend:

g) für Gruppen, welche Grade aufweisen, die Produkte außerhalb der vorgegebenen Toleranzen kennzeichnen, Einstellen der nachgeschalteten Produktionsausrüstung der Produktionslinie (32), um jede solche Gruppe von Produkten mit dem ähnlichen Grad zu verarbeiten, derart dass diese Gruppe innerhalb der vorgegeben Toleranzen gebracht wird; und

h) gemeinsames Verarbeiten der Gruppe durch Verwendung der nachgeschalteten Produktionsausrüstung, wie bei Schritt (g) eingestellt, um die Produkte der Gruppe innerhalb der vorgegebenen Toleranzen zu bringen.

4. Verfahren nach Anspruch 3, bei welchem der Grad, welcher zu einem Produkt an einem Produktionsschritt zuordenbar ist, mit Informationen verbunden ist zum Einstellen der nachgeschalteten Produktionsausrüstung an Schritt (g), derart um die Gruppe, die mit dem Grad verbunden ist, innerhalb der vorgegebenen Toleranzen zu bringen und wobei die nachgeschaltete Produktionsausrüstung entsprechend zum Verarbeiten dieser Gruppe geeignet ist.

5. Verfahren nach Anspruch 2, bei welchem, falls Gruppen an einem Schritt als außerhalb der vorgegebenen Toleranzen liegend identifiziert werden, Verarbeitungsveränderungen an der Produktionsausrüstung vor diesem Schritt gemacht werden, um zukünftig produzierte Produkte innerhalb der vorgegebenen Toleranzen zu bringen.

6. Verfahren nach Anspruch 2, bei welchem Gruppen, die an einem Schritt als außerhalb der vorgegebenen Toleranzen liegend identifiziert werden, für die weitere Verarbeitung vor Gruppen priorisiert werden, die sich an diesem Schritt innerhalb der vorgegebenen Toleranzen befinden.

7. Verfahren nach Anspruch 6, bei welchem Gruppen an einem Schritt zur weiteren Verarbeitung auf Grund des Grades der Gruppe priorisiert werden, wobei Gruppen von Graden, die deutlichere Abweichungen von den vorgegebenen Toleranzen aufweisen, zur Verarbeitung hinter Gruppen mit Graden, die geringere Abweichung von den vorgegebenen Toleranzen kennzeichnend, positioniert werden.

8. Verfahren nach Anspruch 1, bei welchem der Schritt (e) die Schritte umfasst:

a) Vergleichen, durch einen Prozessor (12), des Grades mit einer Vielzahl von Graden von anderen zuvor verarbeiteten Photovoltaik-Produkten in einer Informationsbank, gespeichert in einem Speicher (12), um einen ähnlichen Grad zu identifizieren, wobei der ähnliche Grad ein Grad ist, der mit vorherigen, die ähnliche Gradinformation aufweisenden Produkten verbunden ist, wobei die Informationsbank weiter Informationen über das Ergebnis des Grades an weiteren Produktionsschritten in der Linie umfasst und wobei die Informationsbank weiter Produktionslinieneinstellinformationen umfasst, welche die Produkte mit ähnlichem Grad in eine vertretbare Toleranz bringt;

b) auf Grund der Ergebnisinformationen des ähnlichen Grades, Bestimmen eines vorhergesagten Ergebnisses des Photovoltaik-Produktes an einen oder mehreren weiteren Produktionsschritten in der Produktionslinie (32); und

c) falls das vorhergesagte Ergebnis sich außerhalb der vorgegebenen Toleranz an einem weiteren Produktionsschritt befindet, Bereitstellen der Produktionslinieneinstellinformationen für den weiteren Produktionsschritt, um die Produktionslinie (32) einzustellen, um das Produkt zu verarbeiten.

9. Verfahren nach Anspruch 8, bei welchem bei Schritt (c):

a) falls das vorhergesagte Ergebnis sich außerhalb der vorgegebenen Toleranz an einem weiteren Produktionsschritt befindet, Speichern des Produkts in einer Produktgruppe von Produkten mit dem gleichen oder ähnlichen Grad bis eine vorgegebene Anzahl von Produkten gespeichert ist;

b) Bereitstellen der Produktionslinieneinstellinformation für diesen Schritt, um die Produktionslinie (32) vor der Verarbeitung der Produkte als eine Gruppe einzustellen; und

c) Einsetzen der Produktgruppe nach dem die Einstellungen gemacht sind und ein Verarbeiten dieser als eine Gruppe, um die gewünschten Leistungstoleranzen zu erreichen.

**10.** Verfahren nach Anspruch 8, bei welchem die Gradinformation entweder auf:

a) den Bewertungsergebnissen für das Produkt an diesem Schritt beruht;

b) der statistischen Auswertung von Bewertungsergebnissen von vorher verarbeiteten Photovoltaik-Produkten an diesem Schritt beruht; oder

c) einem Vergleich beruht von kumulierten bisherigen Bewertungsergebnissen für das Produkt durch die vorherigen Produktionsschritte hinweg im Vergleich zu einer statistischen Auswertung von kumulierten bisherigen Bewertungsergebnissen von vorher verarbeiteten Photovoltaik-Produkten über die gleichen Produktionsschritte hinweg.

**11.** Verfahren nach Anspruch 1, bei welchem Schritt (e) die Schritte umfasst:

a) Aufzeichnen von vorherigen Bewertungen von einer Vielzahl von Photovoltaik-Produkten an vorgegebenen Produktionsschritten in einer Informationsbank, welche in einen Speicher (12) gespeichert wird, wobei sich jede Bewertung durch eine vorherige Verarbeitung von Photovoltaik-Produkten bestimmt;

b) Aufzeichnen von vorherigen Vorgehensweisen in der Informationsbank, die an den Produktionsschritten in Antwort auf die vorherigen Bewertungen und verbundenen Ergebnissen genommen wurden;

c) Kennzeichnen von zumindest einem von den verbundenen Ergebnissen als ein positives Ergebnis;

d) Vergleichen, durch einen Prozessor, des Grades von dem Photovoltaik-Produkt an einem Produktionsschritt mit den vorherigen Bewertungen, um eine vorhergesagte Bewertung für das Produkt zu bestimmen;

e) Bereitstellen von einer der Vorgehensweisen, die mit dem positiven Ergebnis verbunden ist, als Vorgehensweise die in der weiteren Verarbeitung für dieses Produkt hergenommen wird.

**12.** Computerprogramm, welches geeignet ist um das Verfahren nach Anspruch 1 durchzuführen.

**13.** Vorrichtung, welche geeignet ist um Photovoltaik-Produkte herzustellen, umfassend:

a) einen Schaltkreis (14), welcher geeignet ist, um jedes Photovoltaik-Produkt für dessen Eignung zu bewerten, anhand von vorgegebenen Kriterien für ein bevorzugtes Produkt, um Bewertungsergebnisse für das Produkt an jedem Produktionsschritt zu erhalten;

b) einen Schaltkreis (12), welcher geeignet ist, um die Bewertungsergebnisse für das Produkt bei dem Produktionsschritt in einem Speicher (12) zu speichern;

c) einen Schaltkreis (12), welcher geeignet ist, um ein Grad jedem Photovoltaik-Produkt zuzuweisen, anhand von entweder:

i) den Bewertungsergebnissen für das Produkt an dem Schritt;

ii) einem Vergleich von Bewertungsergebnissen für das Produkt an dem Schritt mit einer statistischen Auswertung von Bewertungsergebnissen von zuvor verarbeiteten Photovoltaik-Produkten an diesem Schritt; oder

iii) einem Vergleich von kumulierten bisherigen Bewertungsergebnissen für das Produkt an den vorherigen Produktionsschritten mit einer statistischen Auswertung von kumulierten bisherigen Bewertungsergebnissen von zuvor verarbeiteten Photovoltaik-Produkten über die gleichen Produktionsschritte hinweg;

an jedem solchen Produktionsschritt, repräsentiert der Grad, der kennzeichnet ob das Produkt sich innerhalb oder außerhalb der vorgegebenen Toleranzen befindet, Abweichungen von den vorgegebenen Kriterien für die Photovoltaik-Produkte an diesem Schritt;

d) einen Schaltkreis (12) welcher geeignet ist, um der Grad für das Produkt an diesem Produktionsschritt in einem Speicher zu speichern; und

e) einen Schaltkreis (12), welcher geeignet ist, um der Grad zu verwenden, um zu bestimmen wann und wie das Produkt durch die nachgeschalteten Produktionsschritte verarbeitet wird.

**14.** Datenverarbeitungsvorrichtung umfassend Mittel zum Ausführen des Verfahrens nach Anspruch 1.

**15.** Datenverarbeitungsvorrichtung nach Anspruch 14, wobei die Vorrichtung weiter Mittel zum Ausführen eines Verfahrens umfasst, umfassend:

f) Verbinden dieser Produkte in der Produktionslinie (32) an einen bestimmten Schritt, die den gleichen gespeicherten Grad aufweisen, zusammen in eine Gruppe zur weiteren Verarbeitung als eine Gruppe.

## Revendications

**1.** Procédé de fabrication de produits photovoltaïques dans une ligne de production (32) d'une série d'étapes de production (38, 42, 46, 50, 54, 58, 62, 66, 68), comprenant, à chacune d'une pluralité prédéterminée d'étapes de production intermédiaires de la ligne de production (32) :

a. Evaluer, pour chaque produit photovoltaïque, la conformité sur la base de critères prédéterminés pour un produit préféré, afin d'obtenir des résultats d'évaluation en temps réel pour le produit à chaque étape de production ;
b. mémoriser le résultat d'évaluation pour ce produit par l'étape de production, dans une mémoire (12) ;
c. attribuer une note à chaque produit photovoltaïque, sur la base de soit :

i. les résultats d'évaluation pour ce produit à cette étape ;
ii. une comparaison des résultats d'évaluation pour ce produit à cette étape avec une analyse statistique de résultats d'évaluation de produits photovoltaïques précédemment traités à cette étape ; ou
iii. une comparaison des résultats d'évaluation historiques cumulatifs pour ce produit à des étapes de production passées avec une analyse statistique des résultats d'évaluation historiques cumulatifs de produits photovoltaïques précédemment traités sur les mêmes étapes de production ;

pour chacune telle étape de production, la note identifiant si le produit est à l'intérieur ou à l'extérieur de tolérances prédéterminées, représentant des déviations par rapport aux critères prédéterminés, pour les produits photovoltaïques à telle étape :

d. mémoriser la note pour ce produit à telle étape de production, dans une mémoire (12) ; et
e. utiliser la note pour déterminer quand et comment le produit est traité dans les étapes de production en aval.

2. Procédé selon la revendication 1, comprenant en outre :

f. associer tous les produits dans la ligne de production (32) à une étape particulière, ayant la même note mémorisée, ensemble dans un groupe pour le traitement ultérieur en tant que groupe.

3. Procédé selon la revendication 2, comprenant en outre :

g. pour des groupes ayant des notes indiquant des produits à l'extérieur des tolérances prédéterminées, ajuster l'équipement de production en aval de la ligne de production (32) pour traiter chaque tel groupe de produits avec la même note de sorte d'amener le groupe à l'intérieur des tolérances prédéterminées ; et
h. traiter le groupe ensemble en utilisant l'équipement de production en aval tel qu'ajusté à l'étape (g), afin d'amener les produits du groupe de l'intérieur des tolérances prédéterminées.

4. Procédé selon la revendication 3, dans lequel la note attribuable à un produit à une table de production est associée à une information pour ajuster l'équipement de production en aval à l'étape (g) de sorte d'amener le groupe associé à la note à l'intérieur des tolérances prédéterminées, et dans lequel l'équipement de production en aval est ajusté en conséquence pour le traitement de ce groupe.

5. Procédé selon la revendication 2, dans lequel, si des groupes à une étape sont identifiés comme étant à l'extérieur des tolérances prédéterminées, des modifications de procédé sont réalisées en amont de l'étape sur l'équipement de production afin d'amener des produits futurs produits à l'intérieur des tolérances prédéterminées.

6. Procédé selon la revendication 2, dans lequel des groupes identifiés comme étant à l'extérieur des tolérances prédéterminées à une étape sont classés par ordre de priorité pour le traitement ultérieur après des groupes à cette étape qui sont à l'intérieur des tolérances prédéterminées.

7. Procédé selon la revendication 6, dans lequel des groupes à une étape sont classés par ordre de priorité pour le traitement ultérieur sur la base de la note du groupe, des groupes ayant des notes avec des déviations plus significatives par rapport aux tolérances prédéterminées étant positionnés pour traitement derrière des groupes avec des notes représentant moins de déviations par rapport aux tolérances prédéterminées.

8. Procédé selon la revendication 1, dans lequel l'étape (e) comprend les étapes de :

a. comparer, par un processeur (12) la note avec une pluralité de notes d'autres produits photovoltaïques traités précédemment dans une base de connaissances mémorisées dans une mémoire (12), pour identifier une note similaire, la note similaire étant une note associée à des produits passés ayant une information de note similaire, dans lequel la base de connaissance comprend en outre une information ayant trait au résultat de la note à des étapes de production ultérieures dans la ligne, et dans lequel la base de connaissance comprend en outre une information d'ajustement de ligne de production qui amène les produits de note similaire à obtenir une tolérance acceptable ;

b. sur la base de l'information de résultat de la note similaire, évaluer un résultat prédit du produit photovoltaïque à une ou plusieurs étapes de production ultérieures dans la ligne de production (32) ;

c. si le résultat prédit est à l'extérieur de la tolérance prédéterminée à une étape de production ultérieure, fournir à la ligne de production (32) l'information d'ajustement pour cette étape de production ultérieure, afin d'ajuster la ligne de production à la ligne (32) pour le traitement du produit.

9. Procédé selon la revendication 8, dans lequel à l'étape c :

a. si le résultat prédit est à l'extérieur de la tolérance prédéterminée à une étape de production ultérieure, mémoriser le produit dans un groupe de produits avec des notes identiques ou similaires jusqu'à ce qu'un nombre prédéterminé de produits soit mémorisé ;

b. fournir à la ligne de production (32) l'information d'ajustement pour cette étape, afin d'ajuster la ligne de production (32) avant le traitement des produits en tant que groupe ; et

c. insérer le groupe de produit après que les ajustements aient été faits et traiter les produits en tant que groupe afin d'obtenir les tolérances de performance souhaitées.

10. Procédé selon la revendication 8, dans lequel l'information de note est basée sur soit :

a. les résultats d'évaluation pour ce produit à cette étape ;

b. une analyse statistique des résultats d'évaluation de produits photovoltaïques précédemment traités à cette étape ; ou

c. une comparaison des résultats d'évaluation historiques cumulatifs pour ce produit à travers ses étapes de production passées en comparaison à une analyse statistique des résultats d'évaluation cumulatifs historiques de produits photovoltaïques précédemment traités sur les mêmes étapes de production.

11. Procédé selon la revendication 1, dans lequel l'étape (e) comprend les étapes suivantes :

a. enregistrer des évaluations passées d'une pluralité de produits photovoltaïques à des étapes de production prédéterminées dans une base de connaissance mémorisée dans une mémoire (12), chaque évaluation étant déterminée par un traitement passé de produits photovoltaïques ;

b. enregistrer des lignes de conduite précédentes prises à des étapes de production en réponse auxdites évaluations passées, et les résultats associés, dans ladite base de connaissance ;

c. caractériser au moins l'un desdits résultats associés en tant que résultat positif ;

d. comparer, par un processeur, la note du produit photovoltaïque à une étape de production avec lesdites évaluations passées, pour évaluer une évaluation prédite pour ce produit ; et

e. fournir l'une des lignes de conduite associées au résultat positif en tant que ligne de conduite à prendre dans le traitement ultérieur du produit.

12. Programme d'ordinateur adapté pour réaliser le procédé de la revendication 1.

13. Dispositif adapté pour fabriquer des produits photovoltaïques comprenant :

a. une circuiterie (14) adaptée pour évaluer, pour chaque produit photovoltaïque, la conformité sur la base de critères prédéterminés pour un produit préféré, afin d'obtenir des résultats d'évaluation pour ce produit à chaque étape de production ;

b. une circuiterie (12) adaptée pour mémoriser les résultats d'évaluation pour ce produit par l'étape de production, dans une mémoire (12) ;

c. une circuiterie (12) adaptée pour attribuer une note à chaque produit photovoltaïque sur la base de soit :

i. les résultats d'évaluation pour ce produit à cette étape ;

ii. une comparaison des résultats d'évaluation pour ce produit à cette étape avec une analyse statistique de résultats d'évaluation de produits photovoltaïques précédemment traités à cette étape ; ou

iii. une comparaison des résultats d'évaluation historiques cumulatifs pour ce produit à des étapes de production passées avec une analyse statistique de résultats d'évaluation cumulatifs historiques de produits photovoltaïques précédemment traités sur les mêmes étapes de production ;

à chacune telle étape de production, la note identifiant si le produit est à l'intérieur ou à l'extérieur de tolérances prédéterminées, représentant des déviations par rapport aux critères prédéterminés pour les produits photovoltaïques à telle étape ;

d. une circuiterie (12) adaptée pour mémoriser la note pour ce produit à telle étape de production, dans une mémoire ; et

e. une circuiterie (12) adaptée pour utiliser la note pour évaluer quand et comment le produit est traité à travers les étapes de production en aval.

14. Dispositif de traitement de données comprenant des moyens pour réaliser le procédé de la revendication 1.

15. Dispositif de traitement de données selon la revendication 14, dans lequel le dispositif comprend en outre des moyens pour réaliser une méthode comprenant :

f. associer tous les produits dans la ligne de production (32) à une étape particulière, ayant la même note mémorisée, ensemble dans un groupe pour traitement ultérieur en tant que groupe.

FIG. 1

EP 2 433 311 B1

FIG. 2

START

INITIALIZATION
PROCEDURES   74

MS UNIT
76   MEASURE
UNITS

MS UNIT
ADVANCE,
DISCARDS OR   86
BUFFER UNITS

MS UNIT SEND
78   MEASUREMENT
RESULTS TO
PMC SYSTEM

PMC SYSTEM
80   PROCESSES
DATA

82

PMC SYSTEM
SENDS
HANDLING
INSTRUCTIONS
84   TO MS UNIT

PMC SYSTEM
SENDS FEED-
FORWARD OR
FEED-BACK
RECIPE
INSTRUCTIONS
TO PROCESS
TOOLS

# FIG. 3

ENTERPRISE RESOURCE PLANNING (ERP) SYSTEM

88

28

MANUFACTURING EXECUTION SYSTEM (MES)

PRODUCTION MEASUREMENT AND CONTROL (PMC) SYSTEM

12

14

· · ·

PRODUCTION TOOLS

## FIG. 4

EP 2 433 311 B1

**FIG. 5**

FIG. 6

RECEIVE UPDATED UNIT IDS AND MEASUREMENTS (FROM ALL MS UNITS)

ADD MEASUREMENTS TO EACH UNIT'S "Q" RECORD AND UPDATE TPM STATISTICS

TPM DATABASE

DEFECT CORRELATION DATABASE

APPLY QUALITY ALGORITHM TO EACH UNIT

ALL UNITS PROCESSED ?

NO

YES

UNIT GRADINGS

UPDATE DRT

ORDER INFO FROM ERP OR MES

DETERMINE UNITS TO BE DISCARDED

DETERMINE OPTIMAL SEQUENCING FOR REMAINING UNITS

UPDATE AND SEND DISPOSITION INSTRUCTIONS FOR ALL UNITS

FIG. 7

**FIG. 8**

LOCAL FIELDBUS, COMMUNICATION INTERFACES, POWER INTERCONNECT/DISTRIBUTION, OPERATOR I/F

SENSOR BAY

SENSOR BAY

SENSOR

SENSOR

FIG. 9

**FIG. 10**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009026661 A